(19) Europäisches Patentamt
European Patent Office
Office européen des brevets

(11) EP 4 468 355 A1

(12) # EUROPEAN PATENT APPLICATION
published in accordance with Art. 153(4) EPC

(43) Date of publication:
**27.11.2024 Bulletin 2024/48**

(21) Application number: **22960354.3**

(22) Date of filing: **30.09.2022**

(51) International Patent Classification (IPC):
***H01L 27/12*** *(2006.01)*

(52) Cooperative Patent Classification (CPC):
**H01L 27/12**

(86) International application number:
**PCT/CN2022/123422**

(87) International publication number:
**WO 2024/065738 (04.04.2024 Gazette 2024/14)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(71) Applicants:
- **Boe Technology Group Co., Ltd.**
  **Beijing 100015 (CN)**
- **Hefei Boe Ruisheng Technology Co., Ltd.**
  **Hefei, Anhui 230012 (CN)**

(72) Inventors:
- **HU, Haifeng**
  **Beijing 100176 (CN)**
- **ZENG, Ting**
  **Beijing 100176 (CN)**
- **ZHANG, Xiaoxiang**
  **Beijing 100176 (CN)**
- **LIU, Huan**
  **Beijing 100176 (CN)**
- **ZHA, Xin**
  **Beijing 100176 (CN)**
- **XIAO, Tao**
  **Beijing 100176 (CN)**
- **ZHANG, Renwei**
  **Beijing 100176 (CN)**
- **YANG, Caigui**
  **Beijing 100176 (CN)**
- **QI, Qi**
  **Beijing 100176 (CN)**

(74) Representative: **Hoffmann Eitle**
**Patent- und Rechtsanwälte PartmbB**
**Arabellastraße 30**
**81925 München (DE)**

(54) **LIGHT-EMITTING SUBSTRATE, MANUFACTURING METHOD THEREFOR, AND DISPLAY APPARATUS**

(57) A light-emitting substrate, the light-emitting substrate having a display area and a peripheral area located on at least one side of the display area, the peripheral area comprising a first peripheral area, and the first peripheral area and the display area being arranged at intervals along a first direction; the light-emitting substrate comprises: a base; a first conductive layer disposed on the base; the first conductive layer comprises a plurality of signal lines located in the display area; an insulating layer covering the plurality of signal lines; and a second conductive layer disposed on the insulating layer; wherein the insulating layer comprises a first insulating layer and a second insulating layer which are sequentially stacked in the direction away from the base, and, at least between the first peripheral area and the display area, at least part of the edge of the first insulating layer protrudes out beyond the edge of the second insulating layer.

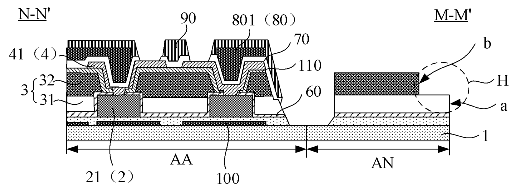


FIG. 2

EP 4 468 355 A1

## Description

### TECHNICAL FIELD

The present disclosure relates to the field of display technologies, and in particular, to a light-emitting substrate, a method of manufacturing a light-emitting substrate, and a display apparatus.

### BACKGROUND

Micro-sized light-emitting diodes, such as mini light-emitting diodes (Mini LEDs) and Micro LEDs, have a size of approximately less than 500 μm, and have a significant increasing usage trend in the display field due to their advantages of small size, ultra-high brightness and long life.

### SUMMARY

In an aspect, a light-emitting substrate is provided. The light-emitting substrate has a display region and a peripheral region located on at least one side of the display region. The peripheral region includes a first peripheral region, and the first peripheral region and the display region are spaced apart in a first direction. The light-emitting substrate includes: a substrate; a first conductive layer disposed on the substrate, the first conductive layer including a plurality of signal lines located in the display region; an insulating layer covering the plurality of signal lines; and a second conductive layer disposed on the insulating layer. The insulating layer includes a first insulating layer and a second insulating layer sequentially stacked in a direction away from the substrate; and at least between the first peripheral region and the display region, at least part of edges of the first insulating layer exceeds an edge of the second insulating layer.

In some embodiments, at least between the first peripheral region and the display region, a slope angle of the at least part of the edges of the first insulating layer and a slope angle of the edge of the second insulating layer are each less than or equal to 45°.

In some embodiments, the at least part of the edges of the first insulating layer includes a first slope surface; the edge of the second insulating layer includes a second slope surface; and the first slope surface and the second slope surface are connected through a first plane of the first insulating layer.

In some embodiments, the second conductive layer includes a plurality of pads located in the display region, the plurality of signal lines and the plurality of pads are located in the display region, and the plurality of signal lines extend along the first direction and are arranged at intervals along a second direction, the second direction intersecting the first direction; the light-emitting substrate includes a plurality of conductive portions located in the first peripheral region, the plurality of conductive portions being located in the second conductive layer; and an end of a conductive portion close to the display region overlaps edges of the first insulating layer and the second insulating layer, extends to the display region, and penetrates through the insulating layer to be connected to a signal line.

In some embodiments, the second insulating layer is located in the first peripheral region, and is located between the substrate and the conductive portions.

In some embodiments, a distance by which the at least part of the edges of the first insulating layer exceeds the edge of the second insulating layer is in a range of 20 μm to 40 μm.

In some embodiments, a thickness of the insulating layer is h1, a thickness of the first conductive layer is h2, and h1 and h2 satisfy:

$$\frac{1}{8} < \frac{h2}{h1} < \frac{7}{8}.$$

In some embodiments, a ratio of a thickness of the first insulating layer to a thickness of the second insulating layer is greater than 0.9 and less than 1.1.

In some embodiments, a thickness of the first insulating layer is less than a thickness of the first conductive layer, and the first insulating layer surrounds each signal line.

In some embodiments, a thickness of the second conductive layer is less than a thickness of the first conductive layer.

In some embodiments, a thickness of the second insulating layer is greater than or equal to 7.5 μm.

In some embodiments, the light-emitting substrate further includes: a first passivation layer disposed between the first insulating layer and the second insulating layer, wherein the second conductive layer includes a plurality of pads located in the display region, and at least part of the pads penetrates through the insulating layer and the first passivation layer to be connected to a signal line.

In some embodiments, a thickness of the second conductive layer is less than a thickness of the first conductive layer.

In some embodiments, the at least part of the edges of the first insulating layer exceeds an edge of the first passivation layer, and at least part of edges of the first passivation layer exceeds the edge of the second insulating layer.

In some embodiments, the second insulating layer includes a first insulating sub-layer and a second insulating sub-layer that are sequentially stacked in the direction away from the substrate. The light-emitting substrate further includes a second passivation layer disposed between the first insulating sub-layer and the second insulating sub-layer. A pad further penetrates through the second passivation layer to be connected to a signal line.

In some embodiments, at least part of edges of the first insulating sub-layer exceeds an edge of the second passivation layer, and at least part of edges of the second passivation layer exceeds an edge of the second insulating sub-layer.

In some embodiments, the peripheral region further includes a bonding region, and the bonding region and the display region are spaced apart in the first direction; and the light-emitting substrate includes: a plurality of bonding pins located in the bonding region, the plurality of bonding pins being located in the first conductive layer.

In some embodiments, the light-emitting substrate has the display region, the display region includes a plurality of display unit regions, the second conductive layer includes a plurality of pad pairs located in each display unit region, each pad pair includes two pads, and the two pads are a first pad and a second pad. The light-emitting substrate further includes at least one light-emitting device and a driver chip located in the display unit region and located on the second conductive layer; the light-emitting device is connected to one pad pair, and the driver chip is connected to at least two pad pairs. The first pad in each pad pair is connected to a signal line; and among a plurality of pad pairs located in the same display unit region, a second pad in a pad pair connected to a light-emitting device is connected to second pads in pad pairs connected to a driver chip.

In some embodiments, the light-emitting substrate further includes: a third passivation layer disposed between the insulating layer and the second conductive layer, and at least one raised portion located in the display unit region; the raised portion is disposed between the insulating layer and the passivation layer. Orthographic projections of the pads on the substrate partially overlap with an orthographic projection of the raised portion on the pads.

In some embodiments, the first pad includes a first sub-portion and a second sub-portion that are connected to each other, the first sub-portion is connected to the signal line, and an orthographic projection of the second sub-portion on the substrate is located within the orthographic projection of the raised portion on the pads.

In some embodiments, the light-emitting substrate further includes: disposed on a side of the third passivation layer away from the insulating layer, wherein the reflective layer includes a plurality of third openings, at least one pad is located in a third opening, and the raised portion is located in a third opening.

In some embodiments, a thickness of the raised portion is h3, a thickness of the reflective layer is h4, and h3 and h4 satisfy:

$$0.5 < \frac{h3}{h4}.$$

In some embodiments, the plurality of signal lines include a plurality of device power signal lines, a plurality of data signal lines, a plurality of first chip power signal lines and a plurality of ground signal lines; a first pad in the pad pair connected to the light-emitting device is connected to a device power signal line; and first pads in the at least two pad pairs connected to the driver chip is connected to a data signal line, a first chip power signal line, and a ground signal line.

In some embodiments, a plurality of light-emitting devices are located in the display unit region, and the plurality of light-emitting devices include a red light-emitting device, a green light-emitting device and a blue light-emitting device; and a first pad in a pad pair connected to the green light-emitting device and a first pad in a pad pair connected to the blue light-emitting device are connected and are of an integrated structure.

In some embodiments, the light-emitting substrate further includes: a buffer layer disposed between the first conductive layer and the substrate; a first insulating barrier layer located between the buffer layer and the insulating layer and located between the first conductive layer and the insulating layer; a second insulating barrier layer disposed on a side of the first conductive layer away from the substrate; a light-shielding layer disposed on a side of the second insulating barrier layer away from the substrate, wherein the light-shielding layer includes a plurality of light-shielding patterns, and orthographic projections of the plurality of light-shielding patterns on the substrate at least partially overlap with orthographic projections of the first conductive layer and the second conductive layer on the substrate; and a third insulating layer disposed on a side of the light-shielding layer away from the substrate. The light-emitting device penetrates through the third insulating layer, the light-shielding layer and the second insulating barrier layer to be connected to a pad pair; and the driver chip penetrates through the third insulating layer, the light-shielding layer and the second insulating barrier layer to be connected to at least two pad pairs.

In another aspect, a method of manufacturing a light-emitting substrate is provided. The light-emitting substrate has a display region and a peripheral region located on at least one side of the display region. The method includes: providing a substrate; forming a first conductive layer on the substrate, the first conductive layer including a plurality of signal lines; forming a first insulating layer on the first conductive layer; providing a first mask on a side of the first insulating layer away from the substrate, wherein the first mask has a frame, and the frame blocks at least part of edges of the first insulating layer; forming a second insulating layer through a fourth opening enclosed by the frame of the first mask, so as to obtain an insulating layer including the first insulating layer and the second insulating layer, at least part of the edges of first insulating layer exceeding an edge of the second insulating layer; and forming a second conductive layer on a side of the second insulating layer away from the substrate, wherein the second conductive layer includes a plurality of pads, and at least part of the pads penetrates through the insulating layer to be connected to a signal line.

In some embodiments, forming the first conductive layer on a side of the substrate includes: forming a first conductive film layer on the side of the substrate; coating a surface of the first conductive film layer away from the substrate with a photoresist; providing a second mask on a side of the first conductive film layer away from the substrate; exposing and developing the photoresist by using the second mask to form a plurality of photoresist patterns; and etching the first conductive film layer by using the plurality of photoresist patterns as a mask, so as to form the first conductive layer, the first conductive layer including the plurality of signal lines located in the display region. Forming the first insulating layer on the side of the substrate includes: forming an organic insulating film on the first conductive layer, a first portion of the organic insulating film covering the plurality of signal lines, and a second portion of the organic insulating film surrounding the signal lines; providing the second mask on a side of the organic insulating film away from the substrate; exposing and developing the organic insulating film by using the second mask, so as to remove the first portion and retain the second portion to form the first insulating layer. One of the organic insulating film and the photoresist is made of a photodegradable material, and another of the organic insulating film and the photoresist is made of a photocurable material.

In yet another aspect, a display apparatus is provided, which includes the light-emitting substrate as described in any one of the above embodiments.

## BRIEF DESCRIPTION OF THE DRAWINGS

In order to describe technical solutions in the present disclosure more clearly, the accompanying drawings to be used in some embodiments of the present disclosure will be introduced briefly. However, the accompanying drawings to be described below are merely drawings of some embodiments of the present disclosure, and a person of ordinary skill in the art can obtain other drawings according to those drawings. In addition, the accompanying drawings to be described below may be regarded as schematic diagrams, but are not limitations on actual sizes of products and actual processes of methods involved in the embodiments of the present disclosure.

FIG. 1 is a structural diagram of a light-emitting substrate, in accordance with some embodiments;
FIG. 2 is a sectional view showing a structure of a light-emitting substrate, in accordance with some embodiments;
FIG. 3 is an electron micrograph of an insulating layer, in accordance with some embodiments;
FIG. 4 is a structural diagram of another light-emitting substrate, in accordance with some embodiments;
FIG. 5 is a sectional view taken along the section line D-D' in FIG. 4;
FIG. 6 is a sectional view showing a structure of another light-emitting substrate, in accordance with some embodiments;
FIG. 7 is a sectional view showing a structure of yet another light-emitting substrate, in accordance with some embodiments;
FIG. 8 is a structural diagram of a display unit region of a light-emitting substrate, in accordance with some embodiments;
FIG. 9 is a sectional view showing a structure of a light-emitting substrate, in accordance with some embodiments;
FIG. 10 is a sectional view showing a structure of yet another light-emitting substrate, in accordance with some embodiments;
FIG. 11 is a flow diagram of a method of manufacturing a light-emitting substrate, in accordance with some embodiments;
FIGS. 12A to 12J are diagrams showing structures corresponding to steps of a method of manufacturing a light-emitting substrate, in accordance with some embodiments;
FIGS. 13A to 13F are diagrams showing structures corresponding to steps of a method of forming a first conductive layer and a first insulating layer, in accordance with some embodiments; and
FIG. 14 is a structural diagram of a display apparatus, in accordance with some embodiments.

DETAILED DESCRIPTION

The technical solutions in some embodiments of the present disclosure will be described clearly and completely with reference to the accompanying drawings. However, the described embodiments are merely some but not all embodiments of the present disclosure. All other embodiments obtained by a person of ordinary skill in the art based on embodiments of the present disclosure shall be included in the protection scope of the present disclosure.

Unless the context requires otherwise, throughout the specification and the claims, the term "comprise" and other forms thereof such as the third-person singular form "comprises" and the present participle form "comprising" are construed as an open and inclusive meaning, i.e., "including, but not limited to." In the description of the specification, the terms such as "one embodiment," "some embodiments," "exemplary embodiments," "example," "specific example," or "some examples" are intended to indicate that specific features, structures, materials, or characteristics related to the embodiment(s) or example(s) are included in at least one embodiment or example of the present disclosure. Schematic representations of the above terms do not necessarily refer to the same embodiment(s) or example(s). In addition, the specific features, structures, materials, or characteristics may be included in any one or more embodiments or examples in any suitable manner.

The terms "first" and "second" are used for descriptive purposes only, and are not to be construed as indicating or implying a relative importance or implicitly indicating a number of indicated technical features. Thus, features defined with "first" and "second" may explicitly or implicitly include one or more of the features. In the description of the embodiments of the present disclosure, the term "multiple," "a plurality of" or "the plurality of" means two or more unless otherwise specified.

The phrase "A and/or B" includes the following three combinations: only A, only B, and a combination of A and B.

The use of the phrase "applicable to" or "configured to" herein means an open and inclusive expression, which does not exclude devices that are applicable to or configured to perform additional tasks or steps.

In addition, the phrase "based on" as used herein is meant to be open and inclusive, since a process, step, calculation or other action that is "based on" one or more of the stated conditions or values may, in practice, be based on additional conditions or values exceeding those stated.

The term such as "about," "substantially," and "approximately" as used herein includes a stated value and an average value within an acceptable range of deviation of a particular value. The acceptable range of deviation is determined by a person of ordinary skill in the art, considering measurement in question and errors associated with measurement of a particular quantity (i.e., limitations of a measurement system).

It will be understood that when a layer or element is referred to as being on another layer or substrate, the layer or element may be directly on the another layer or substrate, or there may be intermediate layer(s) between the layer or element and the another layer or substrate.

Exemplary embodiments are described herein with reference to sectional views and/or plan views that are schematic illustrations of idealized embodiments. In the accompanying drawings, thicknesses of layers and areas of regions are enlarged for clarity. Thus, variations in shape with respect to the accompanying drawings due to, for example, manufacturing technologies and/or tolerances may be envisaged. Therefore, the exemplary embodiments should not be construed as being limited to the shapes of the regions shown herein, but including shape deviations due to, for example, manufacturing. For example, an etched region shown to have a rectangular shape generally has a feature of being curved. Therefore, the regions shown in the accompanying drawings are schematic in nature, and their shapes are not intended to show actual shapes of the regions in a device, and are not intended to limit the scope of the exemplary embodiments.

Some embodiments of the present disclosure provide a light-emitting substrate 10, as shown in FIG. 1, the light-emitting substrate 10 has a display region AA and a peripheral region AN disposed on at least one side of the display region AA. FIG. 1 illustrates an example where the peripheral region AN surrounds the display region AA. It can be understood that in some other examples, the peripheral region AN may also be disposed on one, two, or three sides of the display region A.

In some examples, as shown in FIG. 1, the peripheral region AN includes a first peripheral region BN.

For example, the first peripheral region BN and the display region AA are spaced apart along a first direction X.

For example, the display region AA is provided therein with a plurality of signal lines 21.

For example, the peripheral region AN is provided therein with a plurality of bonding pins 22. The plurality of bonding pins 22 are used to connect an external driver chip and part of the signal lines 21.

Film layer structures included in the light-emitting substrate will be introduced below. As shown in FIG. 2, the light-emitting substrate 10 includes: a substrate 1, a first conductive layer 2, an insulating layer 3, and a second conductive layer 4.

It should be noted that, in order to clearly illustrate the film layer patterns of the display region AA and the film layer patterns between the first peripheral region BN and the display region AA, the sectional views taken along the section line N-N' and the section line M-M' in FIG. 1 are combined to obtain the sectional view shown in FIG. 2.

The type of the substrate 1 varies, which may be set according to practical needs.

For example, the substrate 1 may be a rigid substrate. The rigid substrate may be a glass substrate or a

polymethyl methacrylate (PMMA) substrate.

For example, the substrate 1 may be a flexible substrate. The material of the flexible substrate may include any one of plastic, FR-4 grade material, resin, glass, quartz, polyimide (PI), or polymethyl methacrylate (PMMA).

In some examples, as shown in FIG. 2, the first conductive layer 2 is disposed on the substrate 1.

For example, the first conductive layer 2 includes the plurality of signal lines 21 as mentioned above.

For example, a thickness of the first conductive layer 2 may be in a range of 1.5 $\mu$m to 7 $\mu$m. For example, the thickness of the first conductive layer 2 is 1.5 $\mu$m, 3 $\mu$m, 5 $\mu$m, 6 $\mu$m, 7 $\mu$m, etc.

For example, a material of the first conductive layer 2 includes copper (Cu).

For example, the first conductive layer 2 may be formed of a stacked material such as molybdenum niobium alloy (MoNb)/Cu/MoNb by sputtering. The bottom layer of MoNb may be used for improving adhesion, the middle layer of Cu is used for transmitting an electrical signal, and the top layer of MoNb is used for anti-oxidation. The first conductive layer 2 may also be formed by electroplating. A seed layer of molybdenum titanium nickel alloy (MoNiTi) is firstly formed to increase a nucleation density of crystalline grains, and then an anti-oxidation layer MoNiTi is formed after electroplating.

In some examples, as shown in FIG. 2, the insulating layer 3 covers the plurality of signal lines 21.

The structure of the insulating layer 3 varies, which may be set according to practical needs. In addition, there may be one layer of insulating layer 3, or there may be multiple layers of insulating layers 3.

In some examples, as shown in FIG. 2, the second conductive layer 4 is disposed on the insulating layer 3.

For example, the second conductive layer 4 includes a plurality of pads 41.

For example, at least part of the pads 41 is connected to signal lines 21 by penetrating through the insulating layer 3.

For example, the plurality of pads 41 may include pads for connecting functional elements (such as light-emitting devices) and corresponding signal lines; the plurality of pads 41 may also include pads for connecting functional element driver chip(s) and corresponding signal lines.

For example, a thickness of the second conductive layer 4 is approximately 6000 Å.

For example, a material of the second conductive layer 4 includes copper.

For example, the second conductive layer 4 may be made of a stacked material of MoNb (molybdenum niobium alloy)/Cu/CuNi (molybdenum nickel alloy). The bottom layer of MoNb is used for improving adhesion, the middle layer of Cu is used for transmitting an electrical signal, and the top layer of CuNi balances anti-oxidation and firmness of die bonding.

For example, in a process of forming the second conductive layer 4, a metal film may be formed on the insulating layer 3 first, then a layer of photoresist is formed on the metal film, and a part of the photoresist corresponding to a part of the metal film that needs to be etched is removed through exposure and development and then the part of the metal film that needs to be etched is removed through etching.

In the process of manufacturing the light-emitting substrate 10, the insulating layer 3 is prone to film formation defects due to the influence of foreign particles, or when the materials of the first conductive layer 2 and the second conductive layer 4 both include copper, copper ions migrate and grow, which easily break through the insulating layer 3, thus aggravating the film defects of the insulating layer 3 and causing the insulating layer 3 to be destroyed. As a result, the first conductive layer 2 and the second conductive layer 4 are connected to occur a short circuit (i.e., data gate short (DGS) defect), which will reduce the product stability of the light-emitting substrate 10.

In some implementations, in order to improve the product stability of the light-emitting substrate 10, the thickness of the insulating layer 3 is increased to reduce the probability of DGS defect occurring between the first conductive layer 2 and the second conductive layer 4. However, the inventors of the present disclosure have found through research that when the insulating layer 3 have a large thickness, part of edges of the insulating layer 3 has a large step difference, which results in insufficient exposure and development of the photoresist in the part of the metal film that needs to be etched in the process of forming the second conductive layer 4. In this way, when etching the metal film, there exists metal residue in the position where the photoresist is not fully exposed and developed, causing defects in the light-emitting substrate 10 or affecting the reliability of the light-emitting substrate 10.

In light of this, in some embodiments of the present disclosure, as shown in FIG. 2, the insulating layer 3 includes a first insulating layer 31 and a second insulating layer 32 that are sequentially stacked in a direction away from the substrate 1.

For example, a thickness of the first insulating layer 31 and a thickness of the second insulating layer 32 may be the same or different. The embodiments of the present disclosure are not limited thereto.

For example, a material of the first insulating layer 31 and a material of the second insulating layer 32 may be the same or different. The embodiments of the present disclosure are not limited thereto. For example, the first insulating layer 31 and the second insulating layer 32 are made of the same material, and both the first insulating layer 31 and the second insulating layer 32 are over coating (OC) adhesive layers.

For example, at least between the first peripheral region BN and the display region AA, at least part of edges of the first insulating layer 31 exceeds an edge of the second insulating layer 32.

It should be noted that the above description that "an edge of the first insulating layer 31 exceeds an edge of the second insulating layer 32 at least between the first peripheral region BN and the display region AA" means that, in addition to a situation where an edge of the first insulating layer 31 exceeds an edge of the second insulating layer 32 in a region between the first peripheral region BN and the display region AA, there may also be a situation where an edge of the first insulating layer 31 exceeds an edge of the second insulating layer 32 in other region(s), and the embodiments of the present disclosure are not limited thereto.

For example, at a position between the first peripheral region BN and the display region AA and closer to the display region AA, at least part of the edges of the first insulating layer 31 exceeds the edge of the second insulating layer 32.

For example, at least part of the edges of the first insulating layer 31 exceeds the edge of the second insulating layer 32 to form a step-shaped structure.

For example, "at least part of the edges of the first insulating layer 31 exceeds the edge of the second insulating layer 32" means that at least part of the edges of the first insulating layer 31 located in the peripheral region AN exceeds the edge of the second insulating layer 32 located in the peripheral region AN. As shown in FIG. 2, the edge of the first insulating layer 31 exceeds the edge of the second insulating layer 32 in the region H in FIG. 2.

It should be noted that the above "at least part of the edges of the first insulating layer 31 exceeds the edge of the second insulating layer 32" includes: part of the edges of the first insulating layer 31 exceeding the edge of the second insulating layer 32, or all the edges of the first insulating layer 31 exceeding the edge(s) of the second insulating layer 32.

In addition, the edge described here refers to a border of the film layer. For example, the edge of the first insulating layer 31 is the border a of the first insulating layer; the edge of the second insulating layer 32 is the border b of the second insulating layer 32; and the border a of the first insulating layer exceeds the border b of the second insulating layer 32, as shown in FIG. 2.

In the light-emitting substrate 10 provided in some embodiments of the present disclosure, since the insulating layer 3 includes the first insulating layer 31 and the second insulating layer 32, it may be possible to ensure that the insulating layer 3 has a certain thickness and reduce the probability of DGS defect occurring between the first conductive layer 2 and the second conductive layer 4. Since at least part of the edges of the first insulating layer 31 exceeds the edge of the second insulating layer 32, it may be possible to reduce the step difference of part of the edges of the insulating layer 3, and may also reduce the slope angle of the part of edges of the insulating layer 3. In this way, in the subsequent process of forming the second conductive layer 4, the problem of insufficient metal film etching is less likely to occur, and metal residue is less likely to occur. Therefore, it is conducive to improving the yield, safety and stability of the light-emitting substrate 10, and extending the service life of the light-emitting substrate 10.

In some embodiments, at least between the first peripheral region BN and the display region AA, a slope angle of at least part of the edges of the first insulating layer 31 and a slope angle of the edge of the second insulating layer 32 are each less than or equal to 45°.

For example, the slope angle of at least part of the edges of the first insulating layer 31 may be 45°, 44°, 43°, 42°, 40°, etc., and the embodiments of the present disclosure are not limited thereto.

For example, the slope angle of the edge of the second insulating layer 32 may be 45°, 44°, 43°, 42°, 40°, etc., and the embodiments of the present disclosure are not limited thereto.

For example, the slope angle of at least part of the edges of the first insulating layer 31 and the slope angle of the edge of the second insulating layer 32 may be the same or different. The embodiments of the present disclosure are not limited thereto. For example, the slope angle of at least part of the edges of the first insulating layer 31 and the slope angle of the edge of the second insulating layer 32 are the same, which are each 45°.

It should be noted that the slope angle described here refers to an angle between a side surface of the film layer (that is, a plane where the edge of the film layer is located) and a bottom surface of the film layer. When the side surface of the film layer is not a plane, the slope angle of the film layer is an angle between a side surface in contact with the bottom surface of the film layer and the bottom surface of the film layer. For example, the slope angle of the first insulating layer 31 refers to an included angle $\alpha$ between the side surface of the first insulating layer 31 and the bottom surface of the first insulating layer 31; the slope angle of the second insulating layer 32 refers to an included angle $\beta$ between the side surface of the second insulating layer 32 and the bottom surface of the second insulating layer 32; the slope angle of the insulating layer 3 refers to an included angle $\alpha$ between the side surface in contact with the bottom surface of the insulating layer 3 and the bottom surface of the insulating layer 3, as shown in FIG. 3, FIG. 3 is an electron microscope image of the insulating layer 3.

In some examples, the slope angle of at least part of the edges of the first insulating layer 31 is $\alpha$; and the slope angle of the edge of the second insulating layer 32 is $\beta$. The slope angle $\alpha$ of at least part of the edges of the first insulating layer 31 and the slope angle $\beta$ of the edge of the second insulating layer 32 are each less than or equal to 45°. In the subsequent process of forming the second conductive layer 4, insufficient etching problem of the metal film is less likely to occur, so that the metal residue is less likely to appear.

In some embodiments, as shown in FIG. 3, at least part of the edges of the first insulating layer 31 includes a first

slope surface a; and the edge of the second insulating layer 32 includes a second slope surface b.

In some examples, the first slope surface a and the second slope surface b are connected. For example, the first slope surface a and the second slope surface b are directly connected. As another example, the first slope surface a and the second slope surface b are indirectly connected. The embodiments of the present disclosure are not limited thereto.

For example, the first slope surface a and the second slope surface b are connected through a first plane c of the first insulating layer 31, as shown in FIG. 3.

It should be noted that when the second insulating layer 32 is an organic layer, there will be a leveling tailing phenomenon at the edge of the second insulating layer 32. In this case, the first plane c is not an absolute flat surface, but is an inclined surface with a certain slope.

In this embodiment, by connecting the first slope surface a of the first insulating layer 31 and the second slope surface b of the second insulating layer 32 through the first plane c of the first insulating layer 31, it can reduce the inclination of the edge of the insulating layer, and in turn improve the problem of insufficient etching of the metal film caused by the large slope angle of the insulating layer 3.

In some embodiments, as shown in FIG. 4, the plurality of signal lines 21 and the plurality of pads 41 are located in the display region AA.

For example, the plurality of signal lines 21 extend along a first direction X and are arranged at intervals along a second direction Y, as shown in FIGS. 1 and 4.

For example, the second direction Y and the first direction X intersect.

Here, an included angle between the first direction X and the second direction Y may be set according to practical needs. For example, the included angle between the first direction X and the second direction Y is 85°, 88° or 90°.

In some examples, as shown in FIG. 4, the light-emitting substrate 10 includes a plurality of conductive portions 42.

For example, the plurality of conductive portions 42 are located in the second conductive layer 4.

For example, the plurality of conductive portions 42 are used for connecting the first peripheral region BN and the display region AA.

For example, as shown in FIG. 5, FIG. 5 is a sectional view showing a structure taken along the section line D-D' in FIG. 4, an end of the conductive portion 42 proximate to the display region AA overlaps with edges of the first insulating layer 31 and the second insulating layer 32, extends to the display region AA, and is connected to the signal line 21 penetrating through the insulating layer 3.

In some examples, the first peripheral region BN may be a detection region.

For example, the plurality of conductive portions 42 are used to perform a signal transmission test on the light-emitting substrate 10 to detect whether the plurality of signal lines 21 and the plurality of pads 41 in the light-emitting substrate 10 can normally transmit data signals.

It should be noted that when the first peripheral region BN is a detection region, a region between the first peripheral region BN and the display region AA may be a cutting path region, and the cutting path region connects the display region AA and the first peripheral region BN. After the detection of the light-emitting substrate 10 is completed, the first peripheral region BN and part of the cutting path region are cut off. In some other embodiments, after the detection of the light-emitting substrate 10 is completed, the first peripheral region BN is retained, which is not limited in the embodiments of the present disclosure, as shown in FIG. 1.

In this embodiment, the edge of the first insulating layer 31 exceeds the edge of the second insulating layer 32 between the first peripheral region BN and the display region AA, thus reducing the slope angle of the edge of the insulating layer 3 located between the first peripheral region BN and the display region AA. In the subsequent process of forming the second conductive layer 4, the problem of insufficient etching of the metal film is less likely to appear, so that the metal residue is less likely to occur, and it is difficult to cause the short circuit between the plurality of formed conductive portions 42. Therefore, it is conducive to improving the accuracy of signal transmission detection of the light-emitting substrate 10, and in turn improving the reliability of the light-emitting substrate 10. On this basis, the plurality of conductive portions 42 used to perform the signal transmission detection on the plurality of signal lines 21 and the plurality of pads 41 in the light-emitting substrate 10 are located in the second conductive layer 4, the thickness of the second conductive layer 4 is generally less than the thickness of the first conductive layer 2, which facilitates the subsequent removal of the first peripheral region BN.

In some embodiments, as shown in FIG. 5, the second insulating layer 32 is also located in the first peripheral region BN, and is located between the substrate 1 and the conductive portion 42.

For example, an edge of the second insulating layer 32 away from the display region AA is closer to the display region AA than an edge of the substrate 1 away from the display region, as shown in FIG. 5.

For example, a portion of the first insulating layer 31 located between the first peripheral region BN and the display region AA has a first edge 3101; and a portion of the second insulating layer 32 located between the detection region BN and the display region AA has a second edge 3201 and a third edge 3202.

For example, the first edge 3101 of the first insulating layer 31 exceeds the second edge 3201 of the second

insulating layer 32, so that a step-shaped structure is formed, as shown in FIG. 5.

For example, there is a gap between the second edge 3201 of the second insulating layer 32 and the third edge 3202 of the second insulating layer 32, as shown in FIG. 5.

For example, when the first peripheral region BN needs to be cut off, a region between the first peripheral region BN and the display region AA is a cutting region, and a projection of the second insulating layer 32 on the substrate 1 and the cutting region are staggered. In this case, the film layer in the cutting region is thin, which facilitates cutting.

In this embodiment, the second insulating layer 32 is also located between the conductive portion 42 and the substrate 1. Compared with the case where the conductive portion 42 is directly formed on the substrate 1, it may be possible to avoid the impact of the conductive portion 42 on the substrate 1, which causes defects such as cracks in the substrate 1.

In this way, the slope angle of the edge of the insulating layer 3 located between the first peripheral region BN and the display region AA may be reduced. Therefore, the problem of short circuits between ends of a plurality of second conductive portions 42 close to the display region AA and adjacent second conductive portions 42 may be ameliorated. In addition, the problem of short circuits between ends of a plurality of second conductive portions 42 close to the first peripheral region BN and adjacent second conductive portions 42 may be ameliorated. As a result, it is conducive to improving the accuracy of the signal transmission detection of the light-emitting substrate 10, and improving the reliability of the light-emitting substrate 10.

In some embodiments, a distance by which at least part of the edges of the first insulating layer 31 exceeds the edge of the second insulating layer 32 is in a range of 20 μm to 40 μm. For example, the distance by which the at least part of the edges of the first insulating layer 31 exceeds the edge of the second insulating layer 32 is 20 μm, 25 μm, 30 μm, 35 μm, 40 μm, etc., which is not limited in the embodiments of the present disclosure.

For example, a distance by which the first edge 3101 of the first insulating layer 31 exceeds the second edge 3201 of the second insulating layer 32 is in a range of 20 μm to 40 μm. For example, the distance by which the first edge 3101 of the first insulating layer 31 exceeds the second edge 3201 of the second insulating layer 32 is 20 μm, 25 μm, 30 μm, 35 μm, 40 μm, etc.

It should be noted that the distance by which the at least part of the edges of the first insulating layer 31 exceeds the edge of the second insulating layer 32 may depend on the size of the peripheral region of the light-emitting substrate 10. Those skilled in the art can understand that, in addition to the size of the peripheral region of the light-emitting substrate 10 that needs to be considered, the gentler the slope of the step-shaped structure formed by the at least part of the edges of the first insulating layer 31 exceeding the edge of the second insulating layer 32, the better.

In this embodiment, since the distance by which the at least part of the edges of the first insulating layer 31 exceeds the edge of the second insulating layer 32 is in a range of 20 μm to 40 μm, it may ensure that the problem of insufficient etching of the metal film is not easy to occur in a subsequent process of forming the second conductive layer 4. Thus, metal residues do not easily appear, and the yield of the light-emitting substrate 10 is improved. In addition, it may also ensure that the peripheral region of the light-emitting substrate 10 is narrow, which is conducive to realizing a narrow bezel design of the light-emitting substrate 10 and increasing the screen-to-body ratio.

In some embodiments, the thickness of the insulating layer 3 is h1, the thickness of the first conductive layer 2 is h2, and h1 and h2 satisfy:

$$\frac{1}{8} < \frac{h2}{h1} < \frac{7}{8}.$$

For example, the value of $\frac{h2}{h1}$ may be: $\frac{1}{4}$, $\frac{3}{8}$, $\frac{1}{2}$, $\frac{5}{8}$, $\frac{3}{4}$, etc.

For example, the thickness h1 of the insulating layer 3 refers to the maximum thickness of the insulating layer 3 in a direction perpendicular to the substrate. The thickness h2 of the first conductive layer 2 refers to the thickness of the first conductive layer 2 in the direction perpendicular to the substrate. For example, the thickness h1 of the insulating layer 3 may be 10 μm, and the thickness h2 of the first conductive layer 2 may be 7 μm.

In this way, it can be ensured that the thickness of the insulating layer 3 between the first conductive layer 2 and the second conductive layer 4 is large, which can reduce the probability of DGS failure between the first conductive layer 2 and the second conductive layer 4 and improve the yield of the light-emitting substrate 10.

In some embodiments, a ratio of the thicknesses of the first insulating layer 31 and the second insulating layer 32 is greater than 0.9 and less than 1.1.

For example, the ratio of the thicknesses of the first insulating layer 31 and the second insulating layer 32 may be: 0.93, 0.96, 0.99, 1.02, 1.05, etc.

For example, the thickness of the first insulating layer 31 may be 4 μm, and the thickness of the second insulating

layer 32 may be 4.2 μm.

In this way, it is ensured that the insulating layer 3 has a certain thickness, and the probability of DGS failure between the first conductive layer 2 and the second conductive layer 4 is reduced; furthermore, the thickness of the first insulating layer 31 and the thickness of the second insulating layer 32 have a small difference, which may further reduce the step difference of part of the edges of the insulating layer 3 and reduce the slope angle of part of the edges of the insulating layer 3. Therefore, in the subsequent process of forming the second conductive layer 4, the problem of insufficient etching of the metal film is less likely to occur. As a result, it is conducive to improving the yield of the light-emitting substrate 10.

In some embodiments, as shown in FIG. 2, the thickness of the first insulating layer 31 is less than the thickness of the first conductive layer 2, and the first insulating layer 31 surrounds each signal line 21 in the first conductive layer 2.

For example, an orthographic projection of the first insulating layer 31 on the substrate 1 and orthographic projections of all signal lines 21 on the substrate 1 are complementary to each other.

For example, the method of forming the first conductive layer2 is as follows. First, a conductive film layer is formed through an electroplating process or a sputtering process, where the conductive film layer is made of a metal material with good conductivity, such as copper. Next, the first conductive layer 2 is coated with a photoresist, and a mask is provided to expose and develop the photoresist to form a plurality of photoresist patterns. Then, the conductive film layer is etched to form the first conductive layer 2 by using the plurality of photoresist patterns as a mask. The method of forming the first insulating layer 31 is as follows. There is an organic insulating film on the first conductive layer 2, the organic insulating film partially covers the first conductive layer 2, and the organic insulating film partially surrounds each signal line 21 in the first conductive layer 2. A mask is provided to expose and develop a photoresist to remove a portion of the organic insulating film covering the first conductive layer 2, and a portion of the organic insulating film surrounding each signal line 21 in the first conductive layer 2 is retained. Thus, the first insulating layer 31 is formed.

The first insulating layer 31 surrounds each signal line 21 in the first conductive layer 2. By reasonably selecting the characteristics of the photoresist used in the process of forming the first conductive layer 2 and reasonably selecting the characteristics of the organic insulating film used in the process of forming the first insulating layer 31, the first conductive layer 2 and the first insulating layer 31 may be formed through the same mask, which simplifies the steps of manufacturing the light-emitting substrate 10 and greatly reduces the production cost. For example, in the process of forming the first conductive layer 2, when the conductive film layer is etched through a photolithography process, the photoresist can be a photocurable material, and light-transmissive regions of a mask used in the photolithography process are in one-to-one correspondence with positions of signal lines 21 to be formed. After exposure and development, portions of the photoresist at positions corresponding to the signal lines 21 to be formed are retained, and a portion of the photoresist at a position corresponding to the conductive film layer that need to be etched is removed. In the process of forming the first insulating layer 31, the organic insulating film, for example, can be made of a photodegradable material; in this case, light-transmissive regions of a mask that is used are in one-to-one correspondence with the positions of the signal lines 21. After exposure and development, a portion of the organic insulating film surrounding each signal line 21 is retained, and a portion of the organic insulating film covering each signal line 21 is removed.

In some embodiments, the thickness of the second conductive layer 4 is less than the thickness of the first conductive layer 2.

For example, the first conductive layer 2 is used to arrange various signal lines. If the thickness of the first conductive layer 2 is too small, the resistances of various signal lines will increase. In order to reduce the resistances of various signal lines, the thickness of the first conductive layer 2 is usually large.

For example, the thickness of the first conductive layer 2 is approximately in a range of 1.5 μm to 7 μm.

For example, the second conductive layer 4 is used to provide various pads or leads for connection, and the thickness of the second conductive layer 4 is generally small.

For example, the thickness of the second conductive layer 4 is approximately 6000 Å.

In some embodiments, the thickness of the second insulating layer 32 is greater than or equal to 7.5 μm. For example, the thickness of the second insulating layer 32 may be 7.5 μm, 8 μm, 8.5 μm, etc., which is not limited in the embodiments of the present disclosure.

It should be noted that part of the pads 41 included in the second conductive layer 4 need to penetrate through the insulating layer 3 to be connected to signal lines 21. Therefore, before forming the second conductive layer 4, the insulating layer 3 needs to be etched to form via holes.

For example, as shown in FIG. 2, in the case where the thickness of the first insulating layer 31 is less than the thickness of the first conductive layer 2, there is only the second insulating layer 32 between the first conductive layer 2 and the second conductive layer 4. Part of the pads 41 included in the second conductive layer 4 need to penetrate through the second insulating layer 32 to be connected to signal lines 21.

For example, when the thickness of the first insulating layer 31 is less than the thickness of the first conductive layer 2 and the thickness of the second insulating layer 32 is 7.5 μm, via holes are formed in the second insulating layer 32 through exposure and development.

For example, for the via holes in the second insulating layer 32, the inventors of the present disclosure verify the slope angle of the edge of the second insulating layer 32, the size of the via hole in the second insulating layer 32, and whether there is any material residue at the position of the via hole the second insulating layer 32.
Test results are shown in Table 1.

Table 1

| | 1 | 2 | 3 | 4 | 5 | 6 | 7 | 8 |
|---|---|---|---|---|---|---|---|---|
| Exp.Gap | 150 μm | 200 μm | 250 μm | 300 μm | 150 μm | | | |
| Dev | 120 s | | | | 110 s | 100 s | 90 s | 85 s |
| 1 | 76.02 | 65.58 | 58.37 | 46.62 | 71.50 | 59.65 | 50.31 | 42.15 |
| 2 | 73.43 | 66.36 | 56.62 | 47.74 | 73.87 | 62.13 | 52.68 | / |
| 3 | 74.41 | 67.72 | 55.68 | 48.51 | 72.31 | 60.67 | 48.80 | 37.39 |
| 4 | 71.33 | 61.81 | 51.08 | 44.18 | 68.53 | 55.75 | 40.04 | 22.21 |
| 5 | 73.57 | / | 58.13 | 48.98 | / | 60.83 | 48.89 | 34.17 |
| 6 | 70.23 | 68.11 | 54.44 | 48.28 | 72.60 | 59.95 | 51.84 | 39.06 |
| 7 | 75.79 | 67.64 | 56.46 | 46.47 | 73.28 | 62.81 | 50.18 | 39.06 |
| 8 | 72.28 | 61.56 | 53.53 | 44.82 | 72.30 | 57.48 | / | 27.90 |
| 9 | 79.87 | 68.60 | 55.87 | 49.76 | 74.13 | 62.13 | 52.81 | 40.08 |
| 10 | 76.23 | 65.94 | 53.79 | 45.92 | 71.31 | 59.00 | 47.88 | 38.31 |
| 11 | 81.91 | 72.51 | 58.03 | 50.37 | 76.26 | 62.50 | 49.89 | 43.87 |
| 12 | 81.91 | 72.51 | 61.88 | 51.11 | 77.03 | 65.11 | 60.26 | 46.56 |
| Ave | 75.58 | 67.12 | 56.16 | 47.73 | 73.01 | 60.67 | 50.33 | 37.34 |
| Max | 81.91 | 72.51 | 61.88 | 51.11 | 77.03 | 65.11 | 60.26 | 46.56 |
| Min | 70.23 | 61.56 | 51.08 | 44.18 | 68.53 | 55.75 | 40.04 | 22.21 |
| Via hole CD | 210.74 | 207.75 | 205.57 | 202.91 | 311.32 | 209.37 | 206.71 | 206.22 |
| Whether any CD residue exists | No | No | No | No | No | No | Yes | Yes |

Here, Exp.Gap is a distance between the mask and the second insulating layer 32 during the exposure, and Dev is the exposure time. When the distance between the mask and the second insulating layer 32 is constant and the exposure time is constant, the inventors of the present disclosure select 12 test points, measure a slope angle of the second insulating layer 32 at each test point, and determine an average value Ave of slope angles at the 12 test points, a maximum value Max of the slope angles at the 12 test points, and a minimum value Min of the slope angles at the 12 test points in the case where the distance between the mask and the second insulating layer 32 is constant and the exposure time is constant.
On this basis, when the distance between the mask and the second insulating layer 32 is constant and the exposure time is constant, the inventors of the present disclosure further measure the width of the via hole (the via hole CD) in the second insulating layer 32, and further record whether there is any material residue at the position of the via hole of the second insulating layer 32.
It can be seen from Table 1 that when the distance between the mask and the second insulating layer 32 increases by 50 μm, the slope angle decreases by approximately 10°. In the case were the distance between the mask and the second insulating layer 32 is 150 μm and the development time is less than or equal to 90 s, there will be material residues at the positions of the via holes of the second insulating layer 32, resulting in poor contact between the first conductive layer 2 and the second conductive layer 4 at the positions of the via holes. In the case where the distance between the mask and the second insulating layer 32 is 250 μm and the development time is 120 s, the slope angle of the second insulating layer 32 is approximately 56° and there is no material residue at the position of the via hole of the second insulating layer 32, which may ensure good contact between the first conductive layer 2 and the second conductive layer 4 at the positions of the via holes. That is, the thickness of the second insulating layer 32 is increased to a certain extent to increase the distance between the first conductive layer 2 and the second conductive layer 4, thereby further reducing the probability of short circuits between the first conductive layer 2 and the second conductive layer 4. On this basis, by

changing the distance between the mask and the second insulating layer 32 and the development time, it is still possible to ensure that the slope angle of the second insulating layer 32 is small, and in turn ensure that the problem of insufficient etching of the metal film is less likely to occur in the subsequent process of forming the second conductive layer 4, and thus metal residues do not easily to appear.

In some embodiments, as shown in FIG. 6, the light-emitting substrate 10 further includes a first passivation layer 5 disposed between the first insulating layer 31 and the second insulating layer 32.

For example, part of the pads 41 further penetrates through the first passivation layer 5 to be connected to signal lines 21.

For example, the first passivation layer 5 is made of an inorganic material, such as silicon nitride.

Those skilled in the art can understand that when the materials of the first conductive layer 2 and the second conductive layer 4 both include copper, copper ions are prone to migrate and grow due to the influence of external environments such as foreign particles and voltage. As a result, the first conductive layer 2 and the second conductive layer 4 are short-circuited.

In this embodiment, the first passivation layer 5 is provided between the first insulating layer 31 and the second insulating layer 32. Due to the good density of the inorganic material, the first passivation layer 5 can effectively block the migration and growth of metal ions in the first conductive layer 2 and the second conductive layer 4 towards each other, thereby effectively reducing the probability of short circuits between the first conductive layer 2 and the second conductive layer 4. Therefore, the risk of defects on the light-emitting substrate 10 is reduced, which is conducive to improving the yield, safety and stability of the light-emitting substrate 10 and prolonging the service life of the light-emitting substrate 10.

In some embodiments, as shown in FIG. 6, at least part of the edges of the first insulating layer 31 exceeds an edge of the first passivation layer 5, and at least part of edges of the first passivation layer 5 exceeds an edge of the second insulating layer 32.

For example, "at least part of the edges of the first insulating layer 31 exceeds an edge of the first passivation layer 5, and at least part of the edges of the first passivation layer 5 exceeds an edge of the second insulating layer 32" refers to that: at least part of the edges of the first insulating layer 31 located in the peripheral region AN exceeds an edge of the first passivation layer 5 located in the peripheral region AN, and at least part of the edges of the first passivation layer 5 located in the peripheral region AN exceeds an edge of the second insulating layer 32 located in the peripheral region AN. It should be noted that the above description that "at least part of the edges of the first insulating layer 31 exceeds an edge of the first passivation layer 5, and at least part of the edges of the first passivation layer 5 exceeds an edge of the second insulating layer" has many situations: part of the edges of the first insulating layer 31 exceeds an edge of the first passivation layer 5, part of the edges of the first passivation layer 5 exceeds an edge of the second insulating layer 32; or all edges of the first insulating layer 31 exceed an edge of the first passivation layer 5, and all edges of the first passivation layer 5 exceed an edge of the second insulating layer 32.

For example, at least part of the edges of the first insulating layer 31 exceeds the edge of the first passivation layer 5, and at least part of the edges of the first passivation layer 5 exceeds the edge of the second insulating layer, so that a step-shaped structure is formed. It should be noted that in the above description that "at least part of the edges of the first insulating layer 31 exceeds the edge of the second insulating layer 32 to form a step-shaped structure", the step-shaped structure is composed of the first insulating layer 31 and the second insulating layer 32. In this embodiment, the step-shaped structure is composed of the first insulating layer 31, the first passivation layer 5 and the second insulating layer 32.

In this way, by providing the first passivation layer 5 between the first insulating layer 31 and the second insulating layer 32, it may be possible to effectively block the migration and growth of metal ions in the first conductive layer 2 and the second conductive layer 4 towards each other, and in turn reduce the probability of short circuits between the first conductive layer 2 and the second conductive layer 4. In addition, at least part of the edges of the first insulating layer 31 exceeds the edge of the first passivation layer 5, at least part of the edges of the first passivation layer 5 exceeds the edge of the second insulating layer, so that a step-shaped structure is formed. Therefore, it may reduce a slope angle of part of edges of the first insulating layer 31, the first passivation layer 5 and the second insulating layer 32. In this case, in the subsequent process of forming the second conductive layer 4, the problem of insufficient etching of the metal film is less likely to occur, and metal residues do not easily to appear. As a result, the yield of the light-emitting substrate 10 is improved.

In some embodiments, as shown in FIG. 7, the second insulating layer 32 includes a first insulating sub-layer 321 and a second insulating sub-layer 322 that are stacked in sequence in a direction away from the substrate 1.

For example, a thickness of the first insulating sub-layer 321 and a thickness of the second insulating sub-layer 322 may be the same or different. The embodiments of the present disclosure are not limited thereto.

For example, a material of the first insulating sub-layer 321 and a material of the second insulating sub-layer 322 may be the same or different. The embodiments of the present disclosure are not limited thereto. For example, the first insulating sub-layer 321 and the second insulating sub-layer 322 are made of the same material, and both the first insulating sub-layer 321 and the second insulating sub-layer 322 are over coating (OC) adhesive layers.

In some examples, as shown in FIG. 7, the light-emitting substrate 10 further includes a second passivation layer

6 disposed between the first insulating sub-layer 321 and the second insulating sub-layer 322.

For example, the second passivation layer 6 is made of an inorganic material, such as silicon nitride.

In this embodiment, the second insulating layer 32 includes a first insulating sub-layer 321 and a second insulating sub-layer 322, and a second passivation layer 6 is provided between the first insulating sub-layer 321 and the second insulating sub-layer 322. In an aspect, the distance between the first conductive layer 2 and the second conductive layer 4 can be increased by increasing the number of film layers between the first conductive layer 2 and the second conductive layer 4, thereby effectively reducing the probability of short circuits between the first conductive layer 2 and the second conductive layer 4. In another aspect, the second passivation layer 6 can also be used to effectively block the migration and growth of metal ions in the first conductive layer 2 and the second conductive layer 4 towards each other, thereby further effectively reducing the probability of short circuits between the first conductive layer 2 and the second conductive layer 4, improving the yield, safety and stability of the light-emitting substrate 10, and prolonging the service life of the light-emitting substrate 10.

In some embodiments, as shown in FIG. 7, at least part of edges of the first insulating sub-layer 321 exceeds an edge of the second passivation layer 6, and at least part of edges of the second passivation layer 6 exceeds an edge of the second insulating sub-layer 322.

For example, "at least part of edges of the first insulating sub-layer 321 exceeds an edge of the second passivation layer 6, and at least part of edges of the second passivation layer 6 exceeds an edge of the second insulating sub-layer 322" means that at least part of the edges of the first insulating sub-layer 321 located in the peripheral region AN exceeds an edge of the second passivation layer 6 located in the peripheral region AN, and at least part of the edges of the second passivation layer 6 located in the peripheral region AN exceeds an edge of the second insulating sub-layer 322 located in the peripheral region AN.

It should be noted that the above description that "at least part of the edges of the first insulating sub-layer 321 exceeds the edge of the second passivation layer 6, and at least part of the edge of the second passivation layer 6 exceeds the edge of the second insulating sub-layer 322" includes many situations: part of the edges of the first insulating sub-layer 321 exceeds the edge of the second passivation layer 6, and part of the edges of the second passivation layer 6 exceeds the edge of the second insulating sub-layer 322; or all edges of the first insulating sub-layer 321 exceed an edge of the second passivation layer 322, and all edges of the second passivation layer 6 exceed an edge of the second insulating sub-layer 322.

For example, at least part of the edges of the first insulating sub-layer 321 exceeds the edge of the second passivation layer 6, and at least part of the edges of the second passivation layer exceeds the edge of the second insulating sub-layer 322, so that a step-shaped structure is formed.

It should be noted that the above-mentioned "step-shaped structure" is composed of the first insulating sub-layer 321, the second passivation layer 6 and the second insulating sub-layer 322. For example, the first insulating layer 31, the first insulating sub-layer 321, the second passivation layer 6 and the second insulating sub-layer 322 constitute a step-shaped structure, as shown in FIG. 7.

In this embodiment, the second passivation layer 6 effectively blocks the migration and growth of metal ions in the first conductive layer 2 and the second conductive layer 4 towards each other, thereby further effectively reducing the probability of short circuits between the first conductive layer 2 and the second conductive layer 4. In addition, at least part of the edges of the first insulating sub-layer 321 exceeds the edge of the second passivation layer 6, and at least part of the edges of the second passivation layer 6 exceeds the edge of the second insulating sub-layer 322, so that a step-shaped structure is formed. Therefore, it may reduce a slope angle of part of edges of the first insulating layer 31, the first insulating sub-layer 321, the second passivation layer 6 and the second insulating sub-layer 322. In this case, in the subsequent process of forming the second conductive layer 4, the problem of insufficient etching of the metal film is less likely to occur, and metal residues do not easily to appear. As a result, the yield of the light-emitting substrate 10 is improved.

In some embodiments, the peripheral region AN includes a bonding region BB.

In some examples, there is one bonding region BB. In some other examples, as shown in FIG. 1, there are a plurality of bonding regions BB. For example, the number of bonding regions BB may be two, three or four.

It can be understood that, as shown in FIG. 1, when there are a plurality of bonding regions BB, the plurality of bonding regions BB are located on the same side of the display region AA.

For example, the bonding region BB and the display region AA are spaced apart in a first direction X. For example, when the peripheral region AN includes both the detection region BN and the bonding region BB, the detection region BN and the bonding region BB are located on two opposite sides of the display region AA.

In some examples, the light-emitting substrate 10 includes a plurality bonding pins 22 located in the bonding region BB.

For example, the plurality of bonding pins 22 located in the bonding region BB are used to connect an external driver chip and the signal lines 21 located in the display region AA.

For example, the plurality of bonding pins 22 located in the bonding region BB are electrically connected to the external driver chip by connecting to a flexible circuit board.

For example, one signal line 21 is electrically connected to one bonding pin 22. The external driver chip transmits driving signals to the plurality of bonding pins 22 through the flexible circuit board, and then the plurality of bonding pins 22 transmits the driving signals to the plurality of signal lines 21.

For example, the plurality of bonding pins 22 are located in the first conductive layer 2.

In this embodiment, since the plurality of bonding pins 22 in the bonding region BB are located in the first conductive layer 2, the number of film layers in the bonding region BB may be reduced; the film layers in the bonding region BB have simple structures, which can reduce the probability of detachment between the film layers in the bonding region BB. As a result, the yield of the light-emitting substrate 10 is improved.

In some embodiments, as shown in FIGS. 1 and 8, the display region AA includes a plurality of display unit regions A1.

In some examples, the light-emitting substrate 10 further includes at least one light-emitting device 7 and a driver chip 8 that are located in the display unit region A1 and located on the second conductive layer 4.

There may be one or more light-emitting devices 7 located in the same display unit region A1, and the embodiments of the present disclosure are not limited thereto. For example, the number of light-emitting devices 7 located in the same display unit region A1 may be three, as shown in FIG. 8.

For example, when there are a plurality of light-emitting devices 7 located in the same display unit region A1, the plurality of light-emitting devices 7 may be used to emit light of the same color, or the plurality of light-emitting devices may also be used to emit light of a variety of different colors.

For example, the plurality of light-emitting devices 7 located in the same display unit region A1 are all used to emit white light, or the plurality of light-emitting devices 7 located in the same display unit region A1 are all used to emit blue light, so that the light-emitting substrate 10 can emit light of a specific color.

As another example, the light-emitting devices 7 located in the same display unit region A1 include light-emitting devices of at least three colors, the light-emitting devices of a variety of different colors includes at least a first color, a second color and a third color, and the first color, the second color and the third color are three primary colors (e.g., red, green and blue).

In some examples, the light-emitting devices located in the same display unit region A1 have the same luminance. Luminance of light-emitting devices 7 located in different display unit regions A1 may be the same or different. By controlling the luminance of the light-emitting devices 7 in different display unit regions A1, the brightness of different regions of the light-emitting substrate 10 can be controlled to satisfy different usage requirements.

For example, the light-emitting devices 7 emit light of different brightness under a control of the driver chip 8. Mini LEDs or Micro LEDs are used as the light-emitting devices. Due to the small sizes of the light-emitting devices 7, the human eyes can view a display image from one side of the light-emitting substrate 10.

Compared with a case of using ordinary LEDs as the light-emitting devices, when using mini LEDs or micro LEDs as the light-emitting devices, the light-emitting devices have smaller sizes and higher density, the display image is more detailed, the viewing distance is small, the viewing angle is larger, and the viewing angle may reach 160° or above.

In some examples, as shown in FIG. 8, the second conductive layer 4 includes a plurality of pad pairs 40 located in a respective display unit region A1. For example, each display unit region A1 is provided therein with six pad pairs 40.

For example, each pad pair 40 includes two pads 41, and the two pads 41 are respectively a first pad 411 and a second pad 412.

For example, the first pad 411 in each pad pair 40 is connected to a signal line 21.

For example, in the plurality of pad pairs 40 located in the same display unit region A1, the second pad 412 in the pad pair 40 connected to the light-emitting device 7 and the second pad 412 in the pad pair 40 connected to the driver chip 8 are connected.

In this embodiment, the second pad 412 in the pad pair 40 connected to the light-emitting device 7 is connected to the second pad 412 in the pad pair 40 connected to the driver chip 8, thereby realizing the connection between the light-emitting device 7 and the driver chip 8. Therefore, the driver chip 8 can control the light-emitting device 7 connected thereto to emit light.

In some embodiments, the light-emitting substrate 10 further includes: a third passivation layer 9 and at least one raised portion 20.

In some examples, as shown in FIG. 9, the third passivation layer 9 is disposed between the insulating layer 3 and the second conductive layer 4.

For example, the third passivation layer 9 is made of an inorganic material, such as silicon nitride or silicon oxide.

In some examples, at least one raised portion 20 is located in the display unit region A1.

The raised portion 20 is disposed between the insulating layer 3 and the third passivation layer 9.

A structure of the raised portion 20 varies, which may be set according to practical conditions. In addition, the raised portion 20 may be of one layer or multiple layers. For example, the number of layers of the raised portion 20 is two, as shown in FIG. 9.

In some examples, an orthographic projection of the pad 41 on the substrate 1 overlaps with an orthographic

projection of the raised portion 20 on the substrate 1. In this way, the pad 41 is raised. Therefore, in a die bonding process, when the bottom of the light-emitting device 7 or the driver chip 8 and the pad 41 are soldered through soldering flux, it facilitates a good contact between the light-emitting device 7 or the driver chip 8 and the pad 41, and in turn effectively improves the die bonding yield of the light-emitting substrate 10.

In some embodiments, as shown in FIG. 10, the first pad 411 includes a first sub-portion 4111 and a second sub-portion 4112 connected to each other.

For example, the first sub-portion 4111 is connected to a signal line 21.

For example, an orthographic projection of the second sub-portion 4112 on the substrate 1 is located within the orthographic projection of the raised portion 20 on the substrate 1.

For example, the second sub-portion 4112 is used to connect to the light-emitting device 7 or the driver chip 8.

In this way, the second sub-section 4112 is raised. In the die bonding process, when the bottom of the light-emitting device 7 or the driver chip 8 and the second sub-section 4112 are soldered through soldering flux, it facilitates a good contact between the light-emitting device 7 or the driver chip 8 and the second sub-section 4112, and in turn effectively improves the die bonding yield of the light-emitting substrate 10.

In some embodiments, as shown in FIGS. 9 and 10, the light-emitting substrate 10 further includes a reflective layer 30.

In some examples, the reflective layer 30 is disposed on a side of the third passivation layer 9 away from the insulating layer 3.

For example, a material of the reflective layer 30 is one or more of silver, aluminum, white oil or white adhesive. Silver, aluminum, white oil or white adhesive all have high reflectivity, which can improve the reflection efficiency of light.

For example, as shown in FIGS. 9 and 10, the reflective layer 30 includes a plurality of third openings 301, at least one pad 41 is located in a third opening 301, and a raised portion 20 is located in a third opening 301.

For example, there may be one or more pads 41 located in a single third opening 301. For example, there are two pads 41 located in a single third opening 301, as shown in FIGS. 8 and 9.

It should be noted that when the number of pads 41 located in a single third opening 301 is two, the two pads 41 may be first pads 411, or the two pads 41 may be second pads 412, or the two pads 41 may be a first pad 411 and a second pad 412, as shown in FIG. 9. The embodiments of the present disclosure are not limited thereto. In this embodiment, by providing the reflective layer 30, the light can be reflected, the utilization rate of the light from the light-emitting device 7 is improved, and the light efficiency is increased. For example, when the light emitted downward by the light-emitting device 7 passes through the reflective layer 30, the reflective layer 30 can reflect the light and change it to exit upward instead of passing through the substrate 1. Therefore, the light emitted downward by the light-emitting device 7 is reflected by the reflective layer 30 and is utilized, which improves the utilization rate of the light from the light-emitting device 7 and increases the light efficiency.

On this basis, when the light-emitting substrate 10 includes the reflective layer 30, the light-emitting substrate 10 is used in the backlight to provide backlight.

In some embodiments, a thickness of the raised portion 20 is h3, a thickness of the reflective layer 30 is h4, and h3 and h4 satisfy:

$$0.5 < \frac{h3}{h4}.$$

For example, the value of $\frac{h3}{h4}$ may be: 0.1, 0.2, 0.3, 0.4, etc.

In this embodiment, the reflective layer 30 improves the utilization of light from the light-emitting device 7; in addition, the pads 41 are raised through the raised portion 20, which facilitates a good contact between the light-emitting device 7 or the driver chip 8 and the pads 41, thus effectively improving the die bonding yield of the light-emitting substrate 10.

In some embodiments, as shown in FIG. 8, the plurality of signal lines 21 include a plurality of device power signal lines 211, a plurality of data signal lines 212, a plurality of first chip power signal lines 213, and a plurality of ground signal lines 214.

In some examples, the first pad 411 of the pad pair 40 connected to the light-emitting device 7 is connected to a device power signal line 211.

For example, the device power signal line 211 provides a large constant current voltage to the light-emitting device 7 and then forms a loop with a ground signal line 214.

In some examples, each first pad 411 in at least two pad pairs 40 connected to the driver chip 8 is connected to a data signal line 212, a first chip power signal line 213, and a ground signal line 214.

For example, the first chip power signal line 213 is used to input a voltage signal for providing a working power to the driver chip 8.

For example, the ground signal line 214 is used to ground the driver chip 8.

For example, the light-emitting substrate 10 includes a plurality of second chip power signal lines located in the second conductive layer. The plurality of second chip power signal lines extend in the second direction Y

One first pad 411 in at least two pad pairs 40 connected to the driver chip 8 is connected to a second chip power signal line through a first chip power signal line 213.

In some examples, a plurality of display unit regions P arranged in a line along the first direction X are electrically connected to a set of signal lines 21.

For example, a set of signal lines 21 includes: two device power signal lines 211, one data signal line 212, one first chip power signal line 213 and one ground signal line 214.

In some embodiments, as shown in FIG. 8, there are multiple light-emitting devices 7 located in the same display unit region A1, and the light-emitting devices 7 include a red light-emitting device 71, a green light-emitting device 72 and a blue light-emitting device 73.

In some examples, a first pad 411 of a pad pair 40 connected to the green light-emitting device 72 and a first pad 411 of a pad pair 40 connected to the blue light-emitting device 73 are connected and are of an integrated structure.

For example, the "integrated structure" means that two connected patterns are arranged in the same layer, and the two patterns are continuous and not separated. That is, in the present disclosure, the first pad 411 of the pad pair 40 connected to the green light-emitting device 72 and the first pad 411 of the pad pair 40 connected to the blue light-emitting device 73 are located in the same film layer, and the two first pads 411 are connected to each other.

Since the conversion efficiency of the red light-emitting device 71 is quite different from the conversion efficiency of the blue light-emitting device 73 and the conversion efficiency of the green light-emitting device 72, in this embodiment, the red light-emitting device 71 is connected to one device power signal line 211, and the blue light-emitting device 73 and the green light-emitting device 72 are connected to one device power signal line 211. That is, the power signal of the red light-emitting device 71 is provided separately from the power signals of the blue light-emitting device 73 and the green light-emitting device 72, which may effectively reduce the power consumption of the light-emitting substrate 10.

In some embodiments, as shown in FIGS. 2, 6 and 7, the light-emitting substrate 10 further includes: a buffer layer 50, a first insulating barrier layer 60, a second insulating barrier layer 70, a light-shielding layer 80, and a third insulating layer 90.

In some examples, the buffer layer 50 is disposed between the first conductive layer 2 and the substrate 1.

For example, the buffer layer 50 is made of an inorganic material, such as silicon nitride or silicon oxide. The buffer layer 50 is located between the substrate 1 and the first conductive layer 2, and may protect the substrate 1. Thus, the substrate 1 is not easily broken due to the stress developed by the first conductive layer 2.

In some examples, as shown in FIGS. 2, 6 and 7, the first insulating barrier layer 60 is located between the buffer layer 50 and the insulating layer 3, and is located between the first conductive layer 2 and the insulating layer 3.

For example, the first insulating barrier layer 60 is made of an inorganic material, such as silicon nitride or silicon oxide.

For example, the first insulating barrier layer 60 can isolate the first conductive layer 2 from water and oxygen.

In some examples, the second insulating barrier layer 70 is disposed on a side of the second conductive layer 4 away from the substrate 1.

For example, the second insulating barrier layer 70 is made of an inorganic material, such as silicon nitride or silicon oxide.

For example, the second insulating barrier layer 70 can isolate the second conductive layer 4 from water and oxygen.

In some examples, the light-shielding layer 80 is disposed on a side of the second insulating barrier layer 70 away from the substrate 1.

For example, a material of the light-shielding layer 80 may be a light-shielding insulating material, such as black resin, or may be metal or metal alloy, such as aluminum, silver, magnesium, or magnesium-silver alloy. The embodiments of the present disclosure are not limited thereto.

For example, the light-shielding layer 80 includes a plurality of light-shielding patterns 801, and orthographic projections of the plurality of light-shielding patterns 801 on the substrate 1 at least partially overlap with orthographic projections of the first conductive layer 2 and the second conductive layer 4 on the substrate 1.

For example, the light-shielding layer 80 is used to block light to reduce the reflectivity of the entire light-emitting substrate 10. For example, ambient light irradiates the plurality of signal lines 21 and the plurality of pads 41, the plurality of signal lines 21 and the plurality of pads 41 reflect light, and the reflected light enters human eyes when a viewer is viewing, thus affecting the viewing effect of the viewer. In the present disclosure, by providing the light-shielding layer 80 to block light, the reflectivity of the entire light-emitting substrate 10 is reduced. When the light-emitting substrate 10 is used to display image information, the display effect of the light-emitting substrate 10 may be improved, and the viewing effect of

the viewer may be improved.

On this basis, when the light-emitting substrate 10 includes the light-shielding layer 80, the light-emitting substrate 10 may be directly used as a display panel to display images.

In some examples, the third insulating layer 90 is disposed on a side of the light-shielding layer 80 away from the substrate 1.

For example, the third insulating layer 90 may be an over coating (OC) adhesive layer.

For example, the third insulating layer 90 covers a surface of the second conductive layer 4 away from the substrate 1 to protect the second conductive layer 4. Thus, a part of the surface of the second conductive layer 4 covered by the third insulating layer 90 is not easily oxidized, which retards the corrosion rate of the second conductive layer 4.

In some examples, the light-emitting device 7 penetrates through the third insulating layer 90, the light-shielding layer 80 and the second insulating barrier layer 70 to be connected to a pad pair 40; the driver chip 8 penetrates through the third insulating layer 90, the light-shielding layer 80 and the second insulation barrier layer 70 to be connected to at least two pad pairs 40.

In some examples, the light-emitting substrate 10 further includes a plurality of alignment patterns 100.

For example, as shown in FIGS. 2, 6 and 7, the plurality of alignment patterns 100 are located between the substrate 1 and the buffer layer 50.

For example, the plurality of alignment patterns 100 are used as alignment marks during the evaporation through a mask. For example, the alignment patterns serve as alignment marks for the first conductive layer 2.

In some examples, the light-emitting substrate 10 further includes a fourth passivation layer 110.

For example, the fourth passivation layer 110 is disposed between the second conductive layer 4 and the insulating layer 3, as shown in FIGS. 2, 6 and 7.

For example, the fourth passivation layer 110 is made of an inorganic material, such as silicon nitride or silicon oxide.

For example, by providing the fourth passivation layer 110, the number of film layers between the first conductive layer 2 and the second conductive layer 4 are increased, so that the thickness of the insulating layer between the first conductive layer 2 and the second conductive layer 4 is increased. Therefore, the probability of short circuits between the first conductive layer 2 and the second conductive layer 4 is reduced.

As shown in FIG. 11, some embodiments of the present disclosure further provide a method of manufacturing a light-emitting substrate, which is used to manufacture the light-emitting substrate 10 provided in some of the above embodiments.

FIG. 11 is a flow diagram of the method of manufacturing the light-emitting substrate, in accordance with some embodiments. The method includes steps S1 to S6.

In S1, as shown in FIG. 12A, a substrate 1 is provided.

As for the material of the substrate 1, reference can be made to the description in some of the above embodiments, and details will not be repeated here.

In some examples, after step S1, the method further includes: forming a plurality of alignment patterns 100 on the substrate 1.

In some examples, as shown in FIG. 12B, after forming the plurality of alignment patterns 100 on the substrate 1, the method further includes: forming a buffer layer 50 on the plurality of alignment patterns 100.

For example, the buffer layer 50 is formed by using chemical vapor deposition (CVD) or physical vapor deposition (PVD).

In some examples, as shown in FIG. 12C, after forming the buffer layer 50 on the plurality of alignment patterns 100, the method further includes: forming a seed layer 01 on the plurality of alignment patterns.

For example, the seed layer 01 is formed through a sputtering process, thereby ensuring a uniform thickness of the film layer.

In S2, as shown in FIG. 12D, a first conductive layer 2 is formed on the substrate 1, and the first conductive layer 2 includes a plurality of signal lines 21.

For example, the method of forming the first conductive layer 2 is as follows. First, a conductive film layer is formed through an electroplating process or a sputtering process, and the conductive film layer is made of a metal material with good conductivity, such as copper. Next, the conductive film layer is etched through a photolithography process, so that conductive patterns are formed in the conductive film layer.

The conductive patterns refer to the plurality of signal lines 21 and a plurality of bonding pins 22 included in the first conductive layer 2.

It should be noted that the above-mentioned electroplating process, sputtering process and photolithography process are merely examples of processes used in the forming method and are not process limitations in the practical manufacturing process.

In S3, as shown in FIG. 12E, the first insulating layer 31 is formed on the first conductive layer 2.

As for the material and thickness of the first insulating layer 31, reference can be made to the description in some

of the above embodiments, and details will not be repeated here.

For example, the insulating layer is formed by using a magnetron sputtering process, or chemical vapor deposition (CVD), or physical vapor deposition (PVD).

In some examples, as shown in FIG. 12E, before step S3, the method further includes: forming a first insulating barrier layer 60 on the first conductive layer 2.

The first insulating barrier layer 60 is used to isolate the first conductive layer 2 from water and oxygen.

In S4, as shown in FIG. 12F, a first mask 001 is provided on a side of the first insulating layer 31 away from the substrate 1.

For example, the first mask 001 has a frame a, and the frame a blocks at least part of edges of the first insulating layer 31.

In S5, as shown in FIG. 12F, a second insulating layer 32 is formed through a fourth opening 0010 enclosed by the frame of the first mask 001, so as to obtain an insulating layer 3 that includes the first insulating layer 31 and the second insulating layer 32.

For example, at least part of the edges of the first insulating layer 31 exceeds an edge of the second insulating layer 32 to form a step-shaped structure. In some examples, after forming the second insulating layer 32, the method further includes: etching the second insulating layer 32 to form via holes, so as to expose portions of the signal lines 21.

In some examples, as shown in FIG. 12G, after forming the second insulating layer 32 through the fourth opening enclosed by the frame of the first mask 001, the method further includes: forming a fourth passivation layer 110 on the second insulating layer 32.

In S6, as shown in FIG. 12H, a second conductive layer 4 is formed on a side of the second insulating layer 32 away from the substrate 1.

For example, the second conductive layer 4 includes a plurality of pads 41. For example, at least part of the pads 41 penetrates through the insulating layer 3 to be connected to a signal line 21.

For example, the method of forming the second conductive layer is as follows. First, a conductive film layer is formed through an electroplating process or a sputtering process, and the conductive film layer is made of a metal material with good conductivity, such as copper. Next, the conductive film layer is etched through a photolithography process, so that conductive patterns are formed in the conductive film layer.

The conductive patterns refer to the plurality of pads included in the second conductive layer.

In some examples, as shown in FIG. 12I, after step S6, the method further includes: forming a second insulating barrier layer 70 on the second conductive layer 4.

As for the material of the second insulating barrier layer 70, reference can be made to the description of in some of the above embodiments, and details will not be repeated here.

In some examples, as shown in FIG. 12J, after forming the second insulating barrier layer 70 on the second conductive layer 4, the method further includes: sequentially form ing a light-shielding layer 80 and a third insulating layer 90 on the second insulating barrier layer 70.

For example, both the light shielding layer 80 and the third insulating layer 90 are formed by chemical vapor deposition (CVD) or physical vapor deposition (PVD).

The manufacturing method in the above embodiments of the present disclosure has the same structure and beneficial effects as the light-emitting substrate 10 provided in some embodiments described above, and details will not be repeated here. In some embodiments, forming the first conductive layer 2 on the substrate 1 includes S21 to S25.

In S21, as shown in FIG. 13A, a first conductive film layer 02 is formed on a side of the substrate 1.

In S22, as shown in FIG. 13B, a surface of the first conductive film layer away from the substrate 1 is coated with a photoresist 03.

In S23, as shown in FIG. 13B, the second mask 002 is provided on a side of the first conductive film layer 02 away from the substrate 1.

In S24, as shown in FIG. 13C, the photoresist is exposed and developed by using the second mask to form a plurality of photoresist patterns 031.

For example, orthographic projections, on the substrate 1, of the plurality of photoresist patterns 031 may overlap with orthographic projections, on the substrate 1, of a plurality of signal lines 21 to be formed.

In S25, as shown in FIG. 13D, by using the plurality of photoresist patterns 031 as a mask, the first conductive film layer 02 is etched to form the first conductive layer 2. The first conductive layer 2 includes the plurality of signal lines 21 located in the display region AA.

For example, after step S25, the method further includes removing the plurality of photoresist patterns 031.

Forming the first insulating layer 31 on the first conductive layer 2 includes S31 to S34.

In S31, as shown in FIG. 13E, an organic insulating film 030 is formed on the first conductive layer 2.

For example, a first portion 0301 of the organic insulating film 030 covers the plurality of signal lines 21, and a second portion 0302 of the organic insulating film surrounds the signal lines 21.

In S32, as shown in FIG. 13E, a second mask 002 is provided on a side of the organic insulating film 030 away

from the substrate 1.

In S33, as shown in FIG. 13F, the organic insulating film 030 is exposed and developed using the second mask 002, so as to remove the first portion 0301 and retain the second portion 0302 to form the first insulating layer 31.

For example, one of the organic insulating film 030 and the photoresist 03 is made of a photodegradable material, and the other is made of a photocurable material.

For example, the photoresist 03 is made of a photocurable material, and the photoresist 03 at positions corresponding to the plurality of signal lines 21 to be formed is retained after being irradiated by ultraviolet light. The organic insulating film 030 is made of a photodegradable material; and the photoresist 03 at positions corresponding to the plurality of signal lines 21 may be dissolved in an organic or inorganic alkaline aqueous solution after being irradiated by ultraviolet light, thus being removed. That is, when forming the first conductive layer 2 and the first insulating layer 31, positions that need to be exposed are the same. Therefore, the same mask (i.e., the second mask 002) can be used when forming the first conductive layer 2 and the first insulating layer 31.

It should be noted that the photodegradable material means that: after being irradiated by ultraviolet light, the photodecomposer in an illuminated region decomposes and is soluble in the organic or inorganic alkaline aqueous solution, and the unexposed portion is retained to form the same pattern as a motherboard.

The photocurable material means that: after being irradiated by ultraviolet light, free radicals generated in the illuminated region after the exposure form cross-links between rubber molecules, thus becoming insoluble in the developing solution. That is, the illuminated region is retained after the exposure and development.

In this embodiment, the first conductive layer 2 and the first insulating layer 31 are both formed through one mask (i.e., the second mask 002), which simplifies the manufacturing steps of the light-emitting substrate 10 and greatly reduces the production costs.

As shown in FIG. 14, some embodiments of the disclosure further provide a display apparatus 1000, including the light-emitting substrate 10 as described in any one of the above embodiments.

In some embodiments, the light-emitting substrate 10 is used in display. That is, the light-emitting substrate 10 is directly used as a display panel and can display images, and the display apparatus 1000 is an active light-emitting display apparatus. In this case, since the light-emitting substrate 10 can emit light, there is no need to configure an additional backlight module; and the light-emitting substrate 10 can be directly used as a display panel to display images to be displayed.

In some examples, the images to be displayed are target display images of the display apparatus 1000, which may be all-black, all-white or color images.

For example, when the images to be displayed are color images, the plurality of light-emitting devices located in the same display unit region include light-emitting devices of at least three colors. By controlling the luminous intensities of the light-emitting devices in different display unit regions, red light, green light and blue light of different intensities can be obtained, which enable the display apparatus 1000 to realize full-color image display.

For example, the display apparatus 1000 is a transparent display apparatus, and the substrate 1 is made of a transparent material. For example, the substrate 1 is glass. When the substrate 1 is glass, it can realize two-way light transmission, and it can be applied to indoor screens, transparent display screens, etc.

In some other embodiments, the light-emitting substrate 10 is used in the backlight, and the display apparatus 1000 is a liquid crystal display apparatus. In this case, the display apparatus 1000 further includes a liquid crystal display panel, the light-emitting substrate 10 is used as a light source in the backlight module to provide backlight for the display panel, and the display panel is used to display the images to be displayed.

The light-emitting devices 7 include but are not limited to Mini LEDs, Micro LEDs, etc.

Compared with traditional LEDs, Mini LEDs or Micro LEDs used as light-emitting devices 7 occupy smaller volumes and have smaller particles, and within the same screen size, the light source density per unit area is higher and the light source unit size is smaller. Therefore, more precise local control of the light-emitting devices 7 can be achieved, and the problem of uneven brightness of the light-emitting devices 7 is less likely to occur. That is, the light-emitting substrate 10 is used as a backlight module to provide backlight for the display panel, which may ensure uniform brightness of the backlight and ensure the display quality of the display apparatus 1000.

The foregoing descriptions are merely specific implementations of the present disclosure, but the protection scope of the present disclosure is not limited thereto. Changes or replacements that any person skilled in the art could conceive of within the technical scope of the present disclosure shall be included in the protection scope of the present disclosure. Therefore, the protection scope of the present disclosure shall be subject to the protection scope of the claims.

## Claims

1. A light-emitting substrate, having a display region and a peripheral region located on at least one side of the display region, the peripheral region including a first peripheral region, the first peripheral region and the display region being

spaced apart in a first direction, the light-emitting substrate comprising:

a substrate;
a first conductive layer disposed on the substrate, the first conductive layer including a plurality of signal lines located in the display region;
an insulating layer covering the plurality of signal lines; and
a second conductive layer disposed on the insulating layer;
wherein the insulating layer includes a first insulating layer and a second insulating layer sequentially stacked in a direction away from the substrate; and at least between the first peripheral region and the display region, at least part of edges of the first insulating layer exceeds an edge of the second insulating layer.

**2.** The light-emitting substrate according to claim 1, wherein at least between the first peripheral region and the display region, a slope angle of the at least part of the edges of the first insulating layer and a slope angle of the edge of the second insulating layer are each less than or equal to 45°.

**3.** The light-emitting substrate according to claim 2, wherein the at least part of the edges of the first insulating layer includes a first slope surface; the edge of the second insulating layer includes a second slope surface; and
the first slope surface and the second slope surface are connected through a first plane of the first insulating layer.

**4.** The light-emitting substrate according to any one of claims 1 to 3, wherein the second conductive layer includes a plurality of pads located in the display region, the plurality of signal lines and the plurality of pads are located in the display region, and the plurality of signal lines extend along the first direction and are arranged at intervals along a second direction, the second direction intersecting the first direction; and the light-emitting substrate comprises:

a plurality of conductive portions located in the first peripheral region, the plurality of conductive portions being located in the second conductive layer;
wherein an end of a conductive portion close to the display region overlaps edges of the first insulating layer and the second insulating layer, extends to the display region, and penetrates through the insulating layer to be connected to a signal line.

**5.** The light-emitting substrate according to claim 4, wherein the second insulating layer is located in the first peripheral region, and is located between the substrate and the conductive portions.

**6.** The light-emitting substrate according to any one of claims 1 to 5, wherein a distance by which the at least part of the edges of the first insulating layer exceeds the edge of the second insulating layer is in a range of 20 μm to 40 μm.

**7.** The light-emitting substrate according to any one of claims 1 to 6, wherein a thickness of the insulating layer is h1, a thickness of the first conductive layer is h2, and h1 and h2 satisfy:

$$\frac{1}{8} < \frac{h2}{h1} < \frac{7}{8}.$$

**8.** The light-emitting substrate according to any one of claims 1 to 7, wherein a ratio of a thickness of the first insulating layer to a thickness of the second insulating layer is greater than 0.9 and less than 1.1.

**9.** The light-emitting substrate according to any one of claims 1 to 8, wherein a thickness of the first insulating layer is less than a thickness of the first conductive layer; and
the first insulating layer surrounds each signal line.

**10.** The light-emitting substrate according to any one of claims 1 to 9, wherein a thickness of the second conductive layer is less than a thickness of the first conductive layer.

**11.** The light-emitting substrate according to any one of claims 1 to 10, wherein a thickness of the second insulating layer is greater than or equal to 7.5 μm.

**12.** The light-emitting substrate according to any one of claims 1 to 11, further comprising: a first passivation layer disposed between the first insulating layer and the second insulating layer, wherein the second conductive layer

includes a plurality of pads located in the display region, and at least part of the pads penetrates through the insulating layer and the first passivation layer to be connected to a signal line.

**13.** The light-emitting substrate according to claim 12, wherein the at least part of the edges of the first insulating layer exceeds an edge of the first passivation layer, and at least part of edges of the first passivation layer exceeds the edge of the second insulating layer.

**14.** The light-emitting substrate according to any one of claims 1 to 11, wherein the second insulating layer includes a first insulating sub-layer and a second insulating sub-layer that are sequentially stacked in the direction away from the substrate;
the light-emitting substrate further comprises a second passivation layer disposed between the first insulating sub-layer and the second insulating sub-layer, wherein a pad further penetrates through the second passivation layer to be connected to a signal line.

**15.** The light-emitting substrate according to claim 14, wherein at least part of edges of the first insulating sub-layer exceeds an edge of the second passivation layer, and at least part of edges of the second passivation layer exceeds an edge of the second insulating sub-layer.

**16.** The light-emitting substrate according to any one of claims 1 to 15, wherein the peripheral region further includes a bonding region, and the bonding region and the display region are spaced apart in the first direction; and
the light-emitting substrate further comprises:
a plurality of bonding pins located in the bonding region, the plurality of bonding pins being located in the first conductive layer.

**17.** The light-emitting substrate according to any one of claims 1 to 16, wherein the light-emitting substrate has the display region, the display region includes a plurality of display unit regions, the second conductive layer includes a plurality of pad pairs located in each display unit region, each pad pair includes two pads, and the two pads are a first pad and a second pad;

the light-emitting substrate further comprises at least one light-emitting device and a driver chip located in the display unit region and located on the second conductive layer; the light-emitting device is connected to one pad pair, and the driver chip is connected to at least two pad pairs;
wherein the first pad in each pad pair is connected to a signal line; and
among a plurality of pad pairs located in the same display unit region, a second pad in a pad pair connected to a light-emitting device is connected to second pads in pad pairs connected to a driver chip.

**18.** The light-emitting substrate according to claim 17, further comprising:

a third passivation layer disposed between the insulating layer and the second conductive layer;
at least one raised portion located in the display unit region, the raised portion being disposed between the insulating layer and the third passivation layer;
wherein orthographic projections of the pads on the substrate partially overlap with an orthographic projection of the raised portion on the substrate.

**19.** The light-emitting substrate according to claim 18, wherein the first pad includes a first sub-portion and a second sub-portion that are connected to each other, the first sub-portion is connected to the signal line, and an orthographic projection of the second sub-portion on the substrate is located within the orthographic projection of the raised portion on the substrate.

**20.** The light-emitting substrate according to claim 18 or 19, further comprising:
a reflective layer disposed on a side of the third passivation layer away from the insulating layer, wherein the reflective layer includes a plurality of third openings, at least one pad is located in a third opening, and the raised portion is located in a third opening.

**21.** The light-emitting substrate according to claim 20, wherein a thickness of the raised portion is h3, a thickness of the reflective layer is h4, and h3 and h4 satisfy:

$$0.5 < \frac{h3}{h4}.$$

**22.** The light-emitting substrate according to any one of claims 17 to 21, wherein

the plurality of signal lines include a plurality of device power signal lines, a plurality of data signal lines, a plurality of first chip power signal lines and a plurality of ground signal lines;
a first pad in the pad pair connected to the light-emitting device is connected to a device power signal line; and first pads in the at least two pad pairs connected to the driver chip is connected to a data signal line, a first chip power signal line, and a ground signal line.

**23.** The light-emitting substrate according to any one of claims 17 to 22, wherein

a plurality of light-emitting devices are located in the display unit region, and the plurality of light-emitting devices include a red light-emitting device, a green light-emitting device and a blue light-emitting device; and
a first pad in a pad pair connected to the green light-emitting device and a first pad in a pad pair connected to the blue light-emitting device are connected and are of an integrated structure.

**24.** The light-emitting substrate according to any one of claims 17 to 23, further comprising:

a buffer layer disposed between the first conductive layer and the substrate;
a first insulating barrier layer located between the buffer layer and the insulating layer and located between the first conductive layer and the insulating layer;
a second insulating barrier layer disposed on a side of the first conductive layer away from the substrate;
a light-shielding layer disposed on a side of the second insulating barrier layer away from the substrate, wherein the light-shielding layer includes a plurality of light-shielding patterns, and orthographic projections of the plurality of light-shielding patterns on the substrate at least partially overlap with orthographic projections of the first conductive layer and the second conductive layer on the substrate; and
a third insulating layer disposed on a side of the light-shielding layer away from the substrate;
wherein the light-emitting device penetrates through the third insulating layer, the light-shielding layer and the second insulating barrier layer to be connected to a pad pair; and the driver chip penetrates through the third insulating layer, the light-shielding layer and the second insulating barrier layer to be connected to at least two pad pairs.

**25.** A method of manufacturing a light-emitting substrate, the light-emitting substrate having a display region and a peripheral region located on at least one side of the display region; the method comprising:

providing a substrate;
forming a first conductive layer on the substrate, the first conductive layer including a plurality of signal lines;
forming a first insulating layer on the first conductive layer;
providing a first mask on a side of the first insulating layer away from the substrate, wherein the first mask has a frame, and the frame blocks at least part of edges of the first insulating layer;
forming a second insulating layer through a fourth opening enclosed by the frame of the first mask, so as to obtain an insulating layer including the first insulating layer and the second insulating layer, at least part of the edges of first insulating layer exceeding an edge of the second insulating layer; and
forming a second conductive layer on a side of the second insulating layer away from the substrate, wherein the second conductive layer includes a plurality of pads, and at least part of the pads penetrates through the insulating layer to be connected to a signal line.

**26.** The method according to claim 25, wherein

forming the first conductive layer on a side of the substrate includes:

forming a first conductive film layer on the side of the substrate;
coating a surface of the first conductive film layer away from the substrate with a photoresist;
providing a second mask on a side of the first conductive film layer away from the substrate;
exposing and developing the photoresist by using the second mask to form a plurality of photoresist patterns;

and
etching the first conductive film layer by using the plurality of photoresist patterns as a mask, so as to form the first conductive layer, the first conductive layer including the plurality of signal lines located in the display region; and

forming the first insulating layer on the side of the substrate includes:

forming an organic insulating film on the first conductive layer, a first portion of the organic insulating film covering the plurality of signal lines, and a second portion of the organic insulating film surrounding the signal lines;
providing the second mask on a side of the organic insulating film away from the substrate; and
exposing and developing the organic insulating film by using the second mask, so as to remove the first portion and retain the second portion to form the first insulating layer; wherein one of the organic insulating film and the photoresist is made of a photodegradable material, and another of the organic insulating film and the photoresist is made of a photocurable material.

**27.** A display apparatus, comprising the light-emitting substrate according to any one of claims 1 to 24.

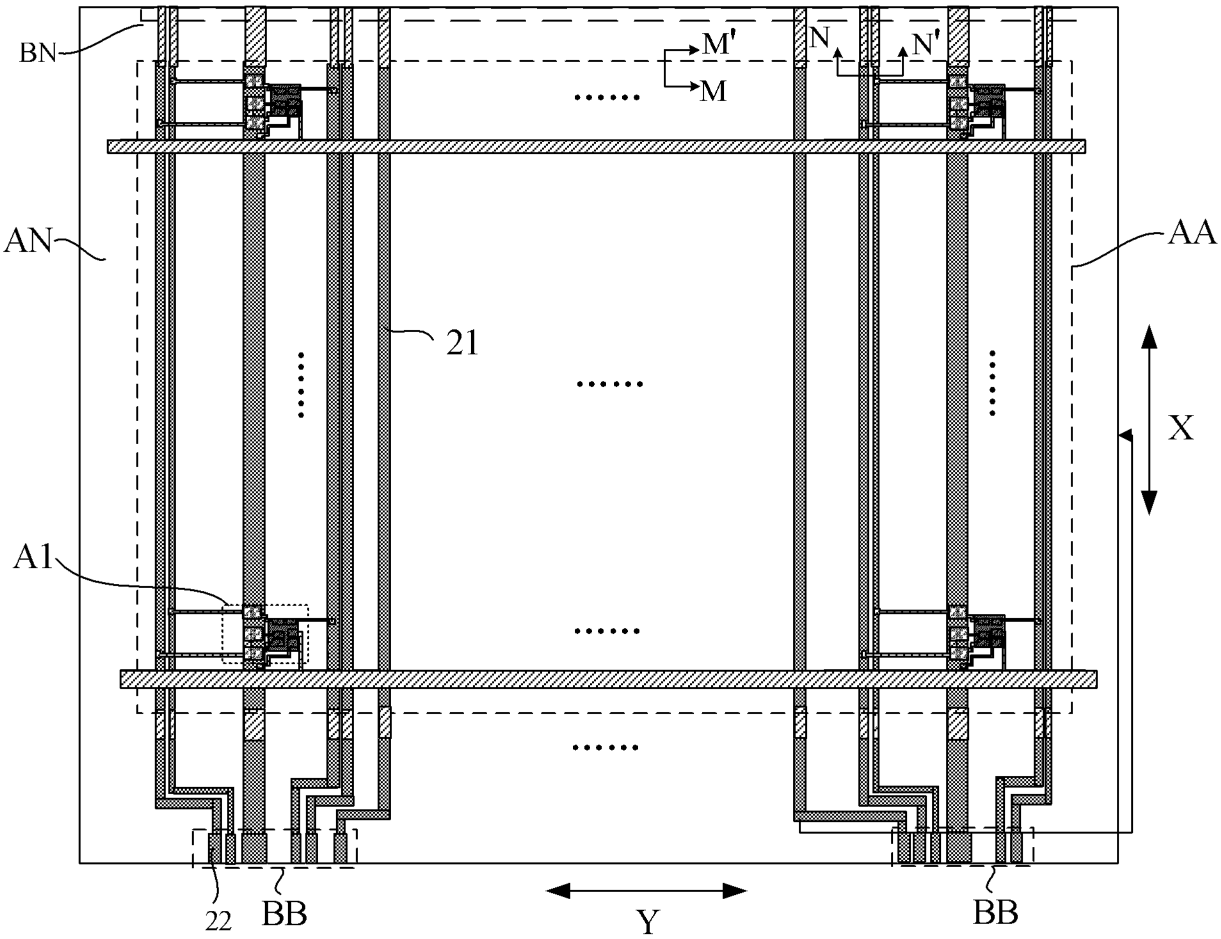
BN
M'
M
N
N'
AN
AA
21
X
A1
22
BB
Y
BB

FIG. 1

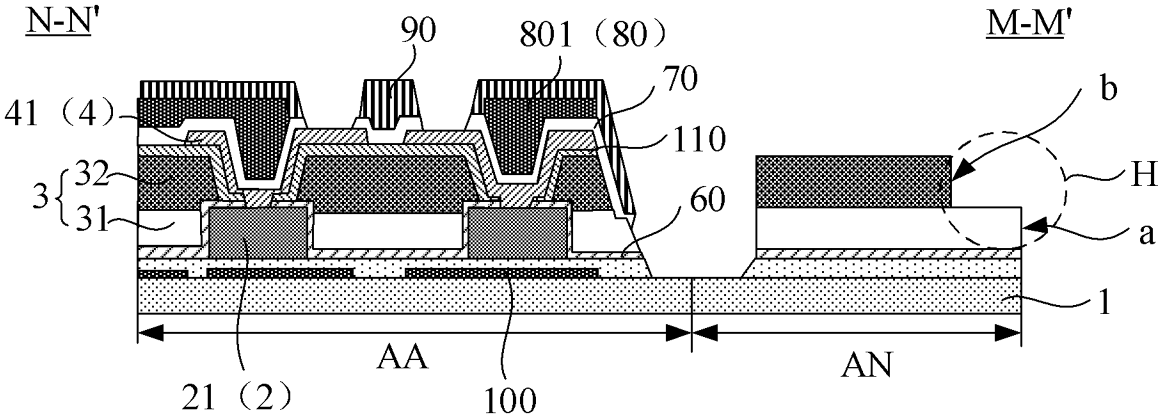
N-N'
M-M'
90
801（80）
70
41（4）
110
b
H
32
3
31
60
a
1
AA
AN
21（2）
100

FIG. 2

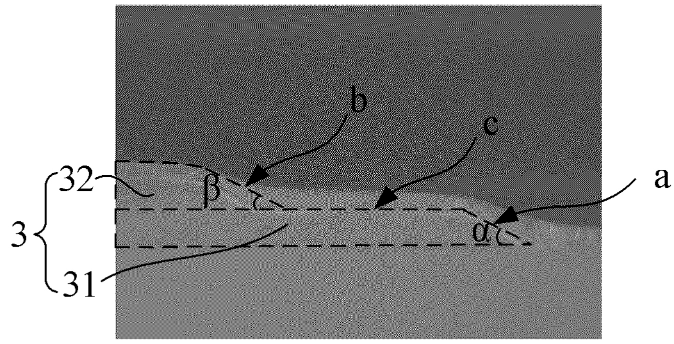


FIG. 3

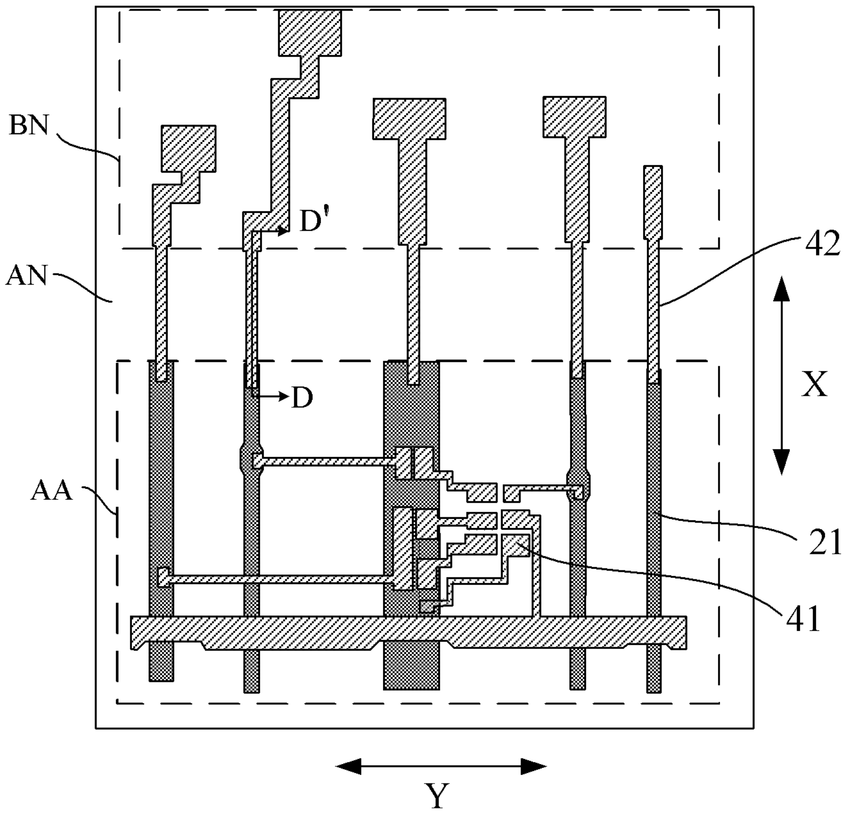


FIG. 4

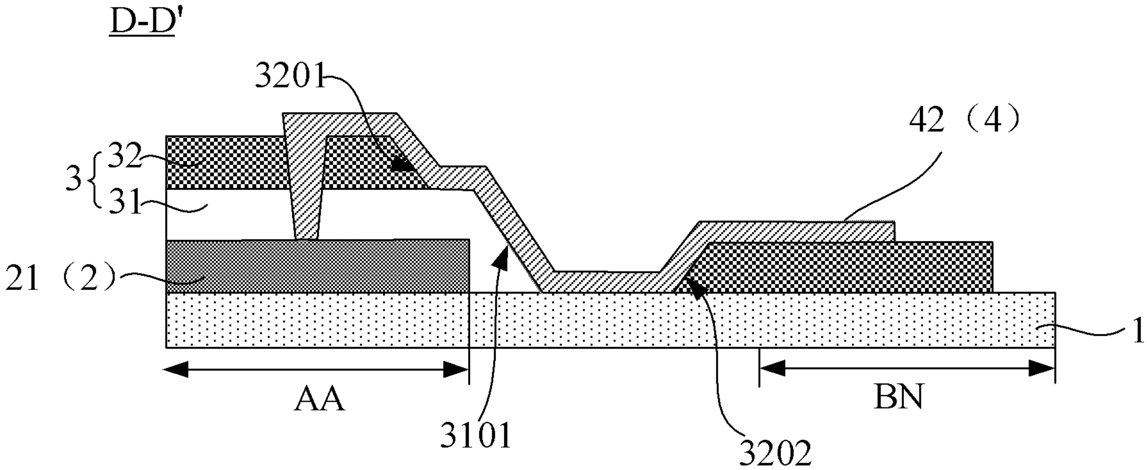


FIG. 5

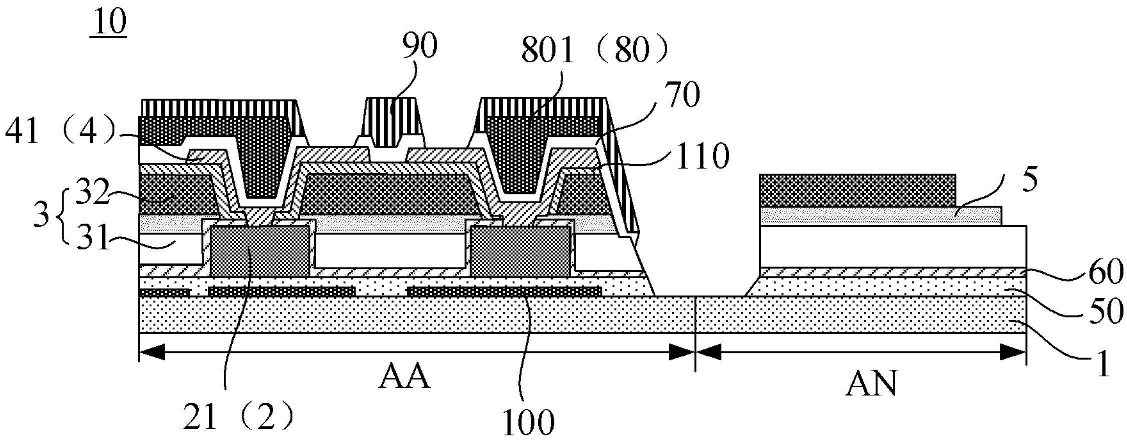


FIG. 6

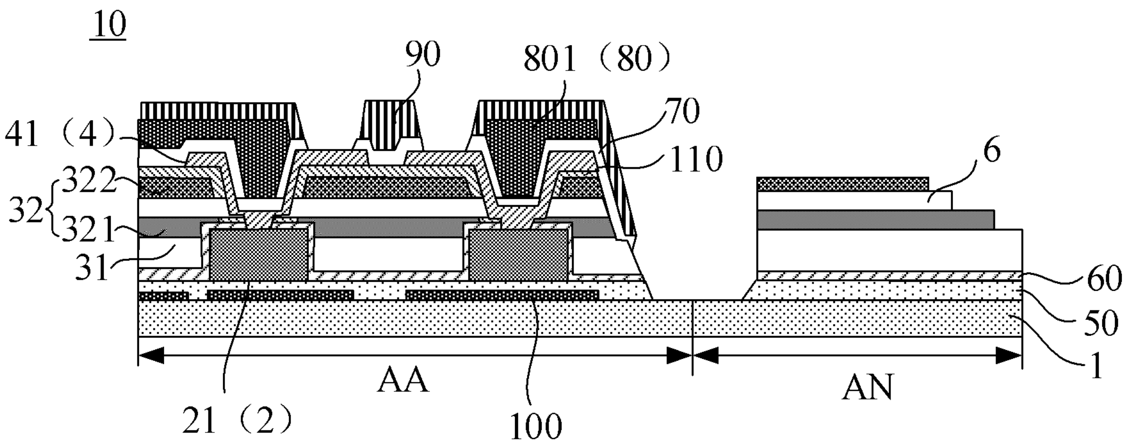


FIG. 7

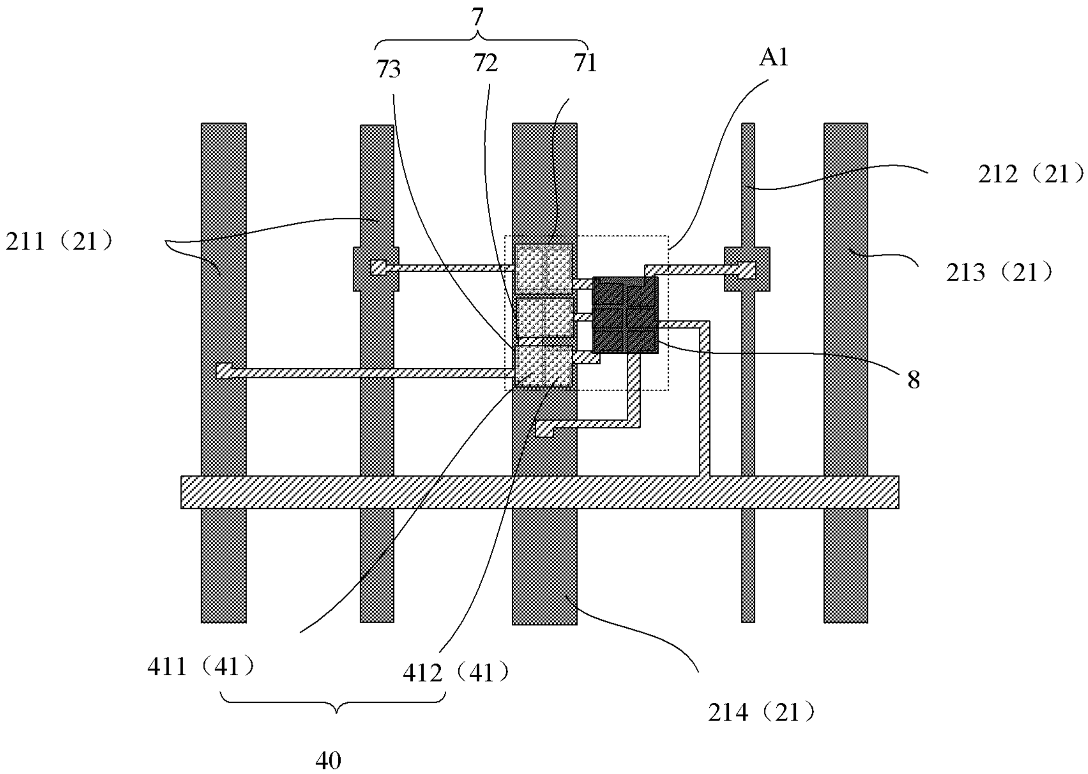
7
73
72
71
A1
212（21）
211（21）
213（21）
8
411（41）
412（41）
214（21）
40

FIG. 8

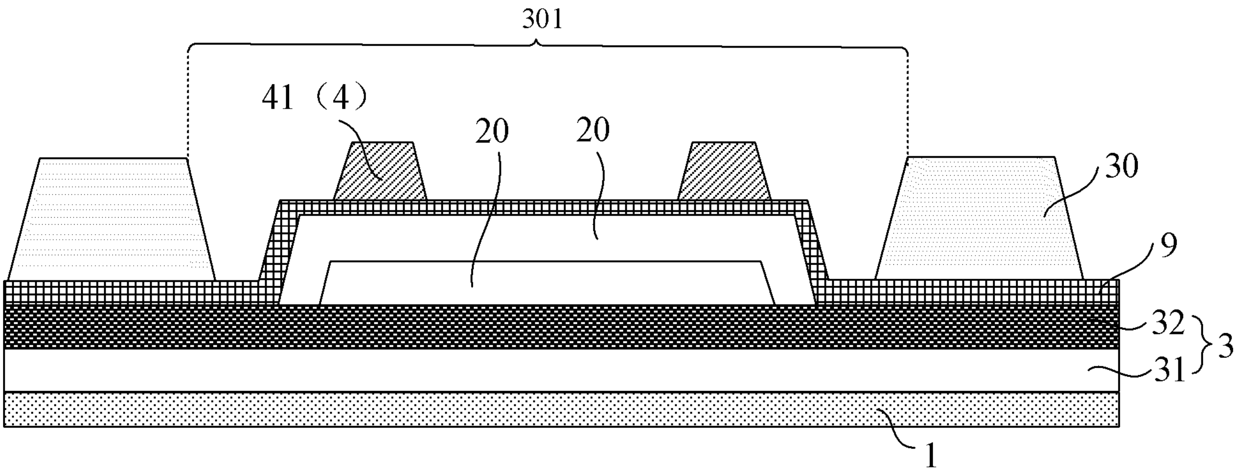
301
41（4）
20
20
30
9
32
3
31
1

FIG. 9

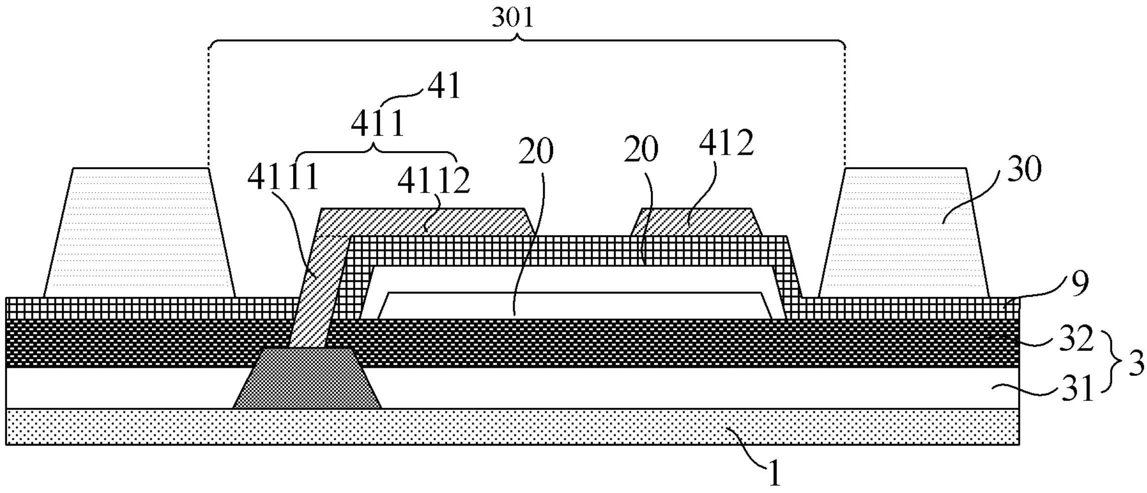
301
41
411
4111
4112
20
20
412
30
9
32
3
31
1

FIG. 10

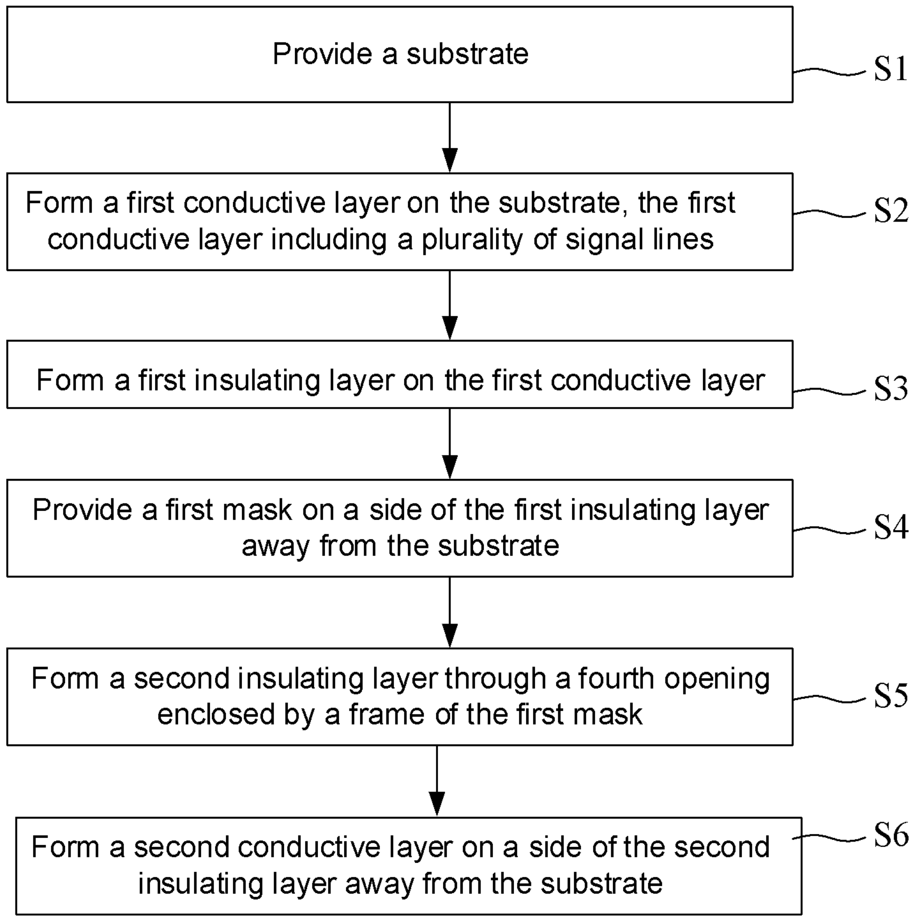
Provide a substrate
S1
Form a first conductive layer on the substrate, the first conductive layer including a plurality of signal lines
S2
Form a first insulating layer on the first conductive layer
S3
Provide a first mask on a side of the first insulating layer away from the substrate
S4
Form a second insulating layer through a fourth opening enclosed by a frame of the first mask
S5
Form a second conductive layer on a side of the second insulating layer away from the substrate
S6

FIG. 11

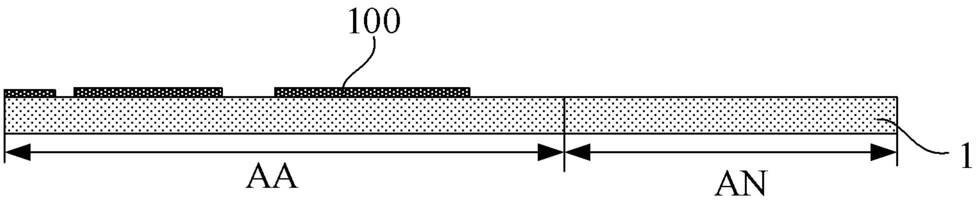


FIG. 12A

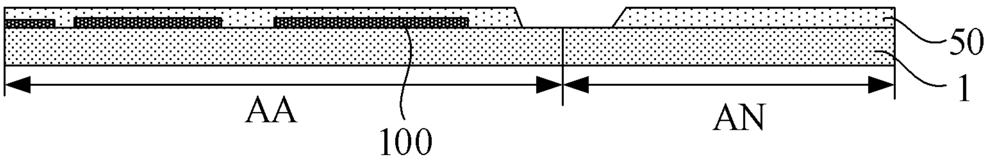


FIG. 12B

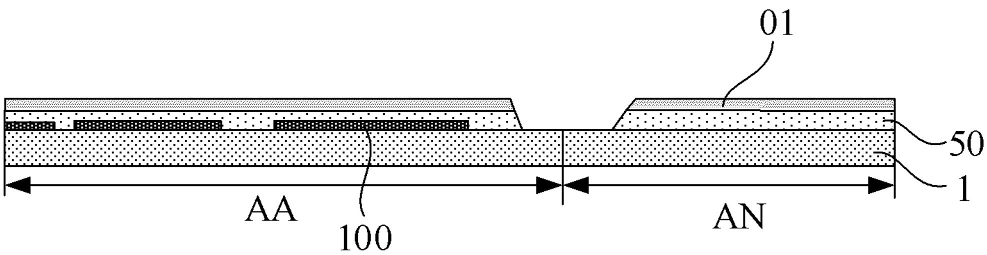


FIG. 12C

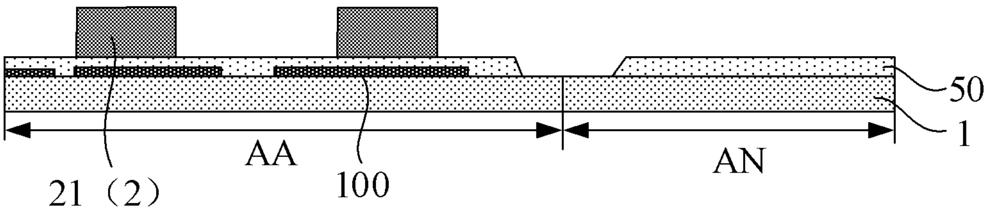


FIG. 12D

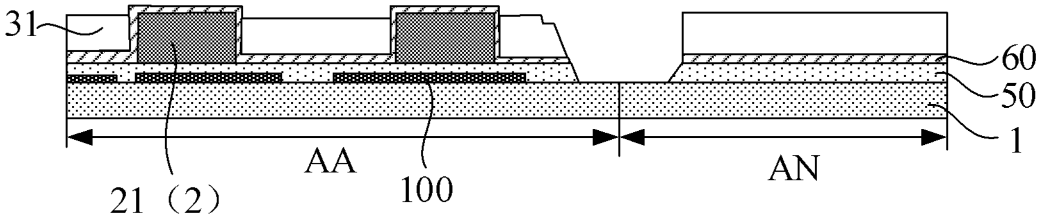


FIG. 12E

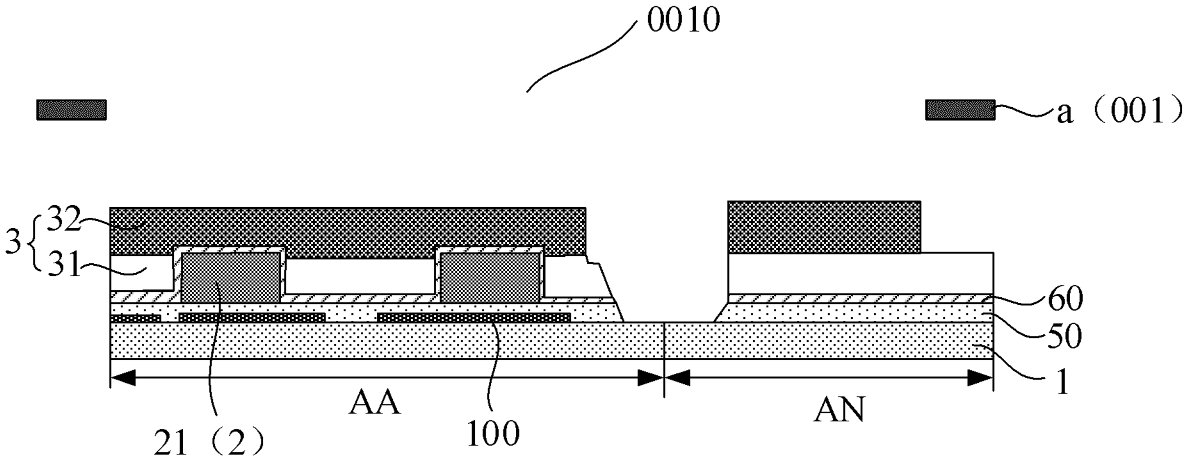


FIG. 12F

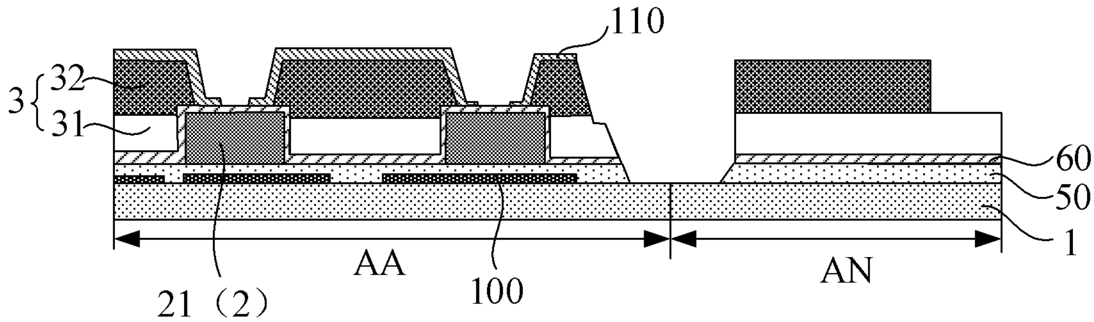


FIG. 12G

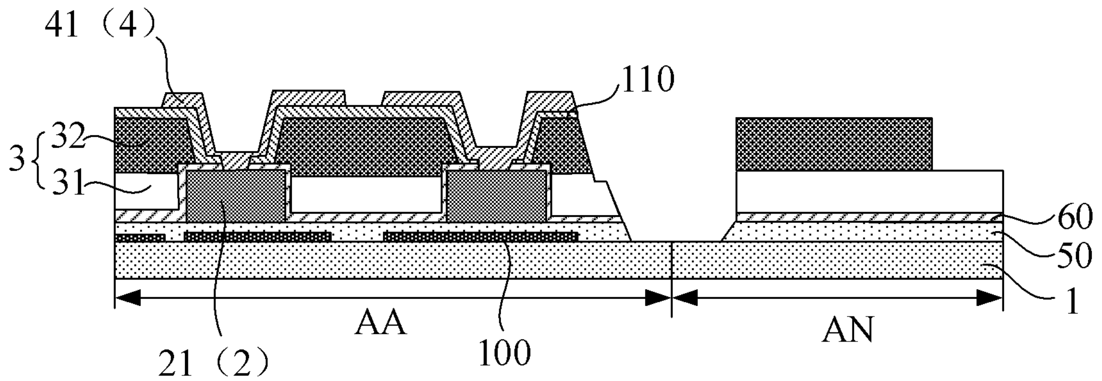


FIG. 12H

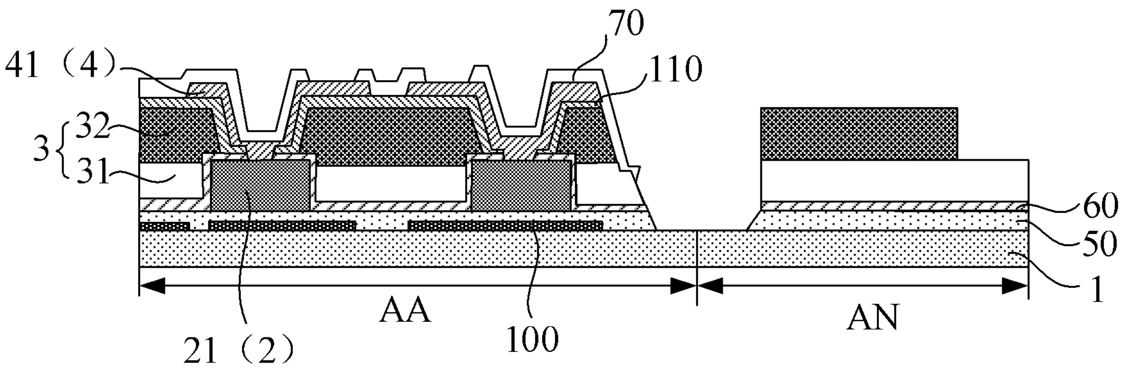


FIG. 12I

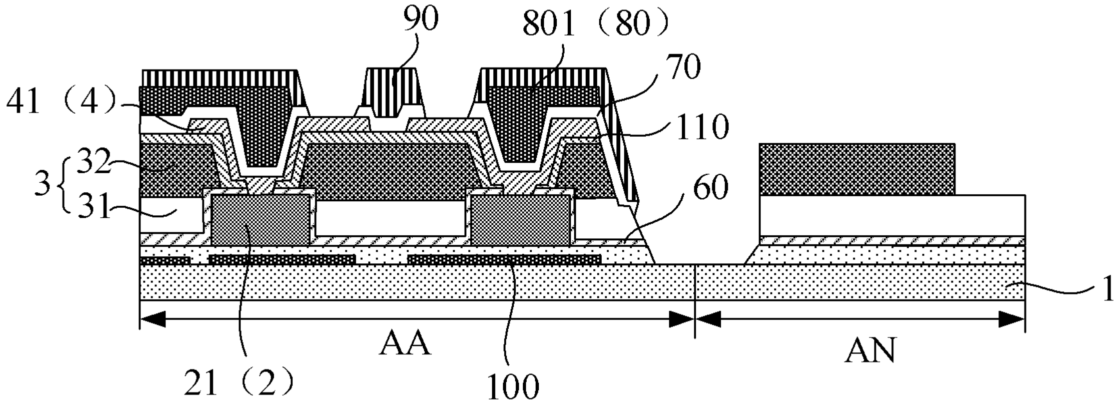


FIG. 12J

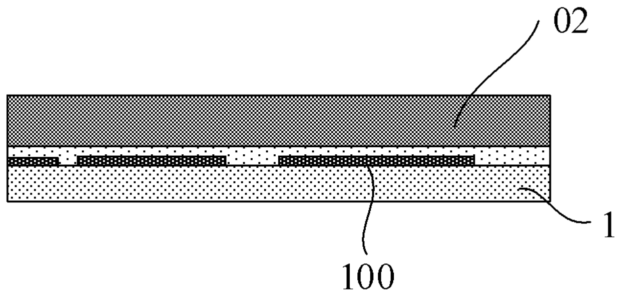


FIG. 13A

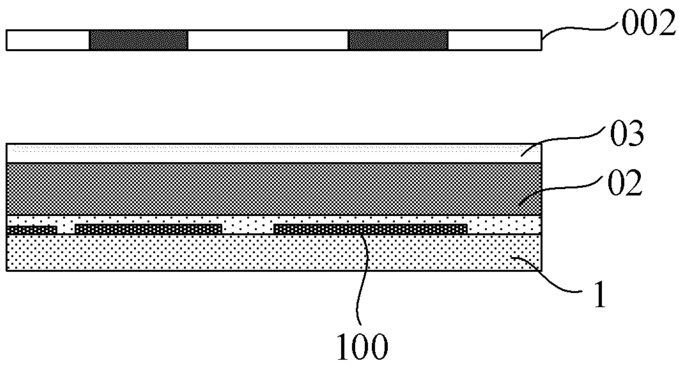


FIG. 13B

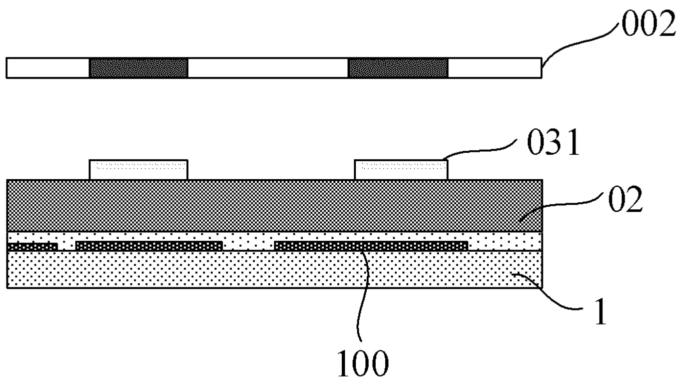


FIG. 13C

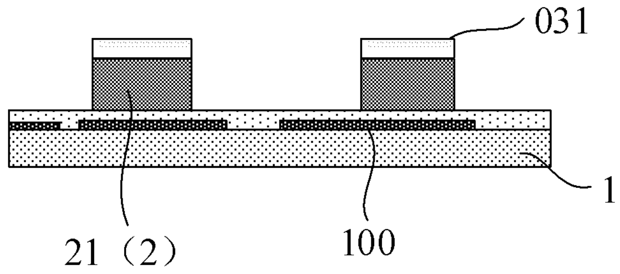


FIG. 13D

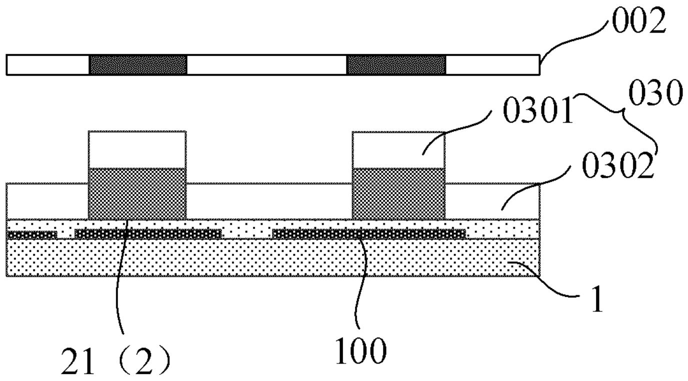


FIG. 13E

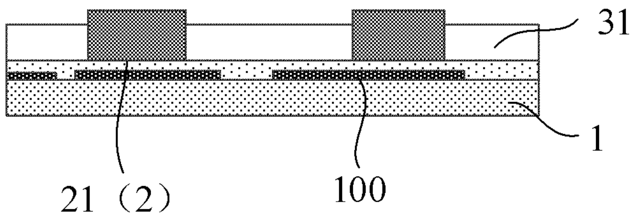


FIG. 13F

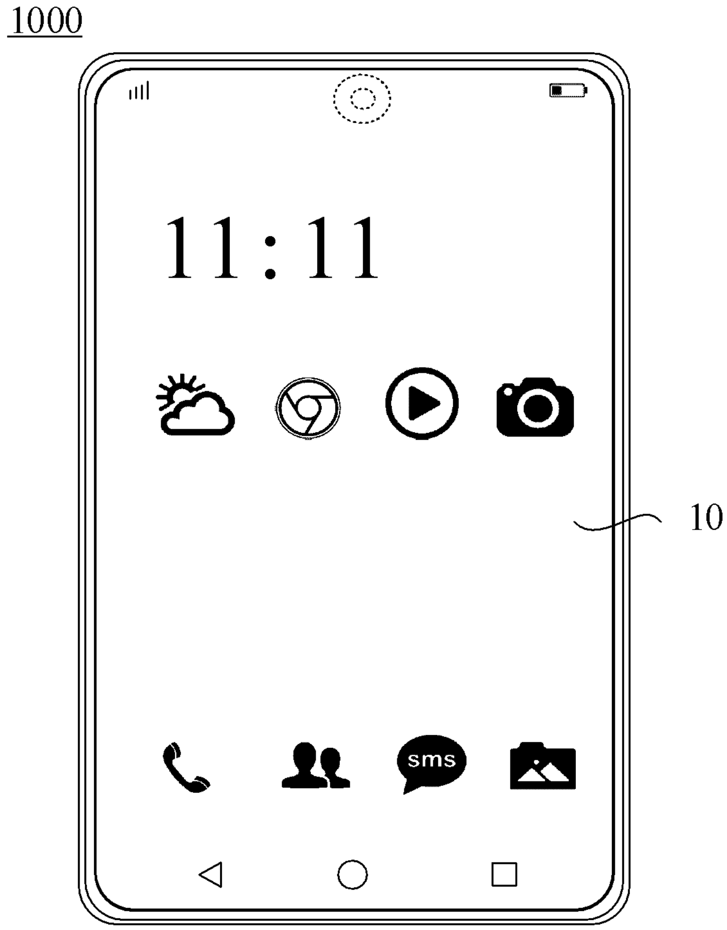


FIG. 14

## INTERNATIONAL SEARCH REPORT

International application No. **PCT/CN2022/123422**

**A. CLASSIFICATION OF SUBJECT MATTER**

H01L27/12(2006.01)i

According to International Patent Classification (IPC) or to both national classification and IPC

**B. FIELDS SEARCHED**

Minimum documentation searched (classification system followed by classification symbols)

IPC: H01L

Documentation searched other than minimum documentation to the extent that such documents are included in the fields searched

Electronic data base consulted during the international search (name of data base and, where practicable, search terms used)

CNABS, CNTXT: 邦定, 绑定, 比, 比值, 边沿, 边缘, 侧边, 台阶, 楼梯, 阶梯, 坡, 坡度角, 残留, 剩余, 残余, 显示区, 像素区, 有效区, 非可视区, 非显示区, 非像素区, 外围, 周边, 焊垫, 焊盘, 厚度, 高度, 深度, 介质膜, 隔绝层, 绝缘, 刻蚀, 蚀刻, 驱动; VEN, USTXT, EPTXT, WOTXT: bond, ratio, edge, side, step, stair, slope, angle, residual, display area, pixel area, active area, non display, peripheral, pad, thickness, height, depth, insulating, etching

**C. DOCUMENTS CONSIDERED TO BE RELEVANT**

| Category* | Citation of document, with indication, where appropriate, of the relevant passages | Relevant to claim No. |
|---|---|---|
| X | JP 2007172873 A (KYOCERA CORP.) 05 July 2007 (2007-07-05) description, paragraphs 17-52, and figures 1-1 to 16 | 1, 4-5, 7-27 |
| Y | JP 2007172873 A (KYOCERA CORP.) 05 July 2007 (2007-07-05) description, paragraphs 17-52, and figures 1-1 to 16 | 2-3, 6 |
| Y | CN 110581143 A (WUHAN CHINA STAR OPTOELECTRONICS SEMICONDUCTOR DISPLAY TECHNOLOGY CO., LTD.) 17 December 2019 (2019-12-17) description, paragraphs 46-94, and figures 1-14 | 2-3, 6 |
| A | CN 104766869 A (HEFEI XINSHENG OPTOELECTRONICS TECHNOLOGY CO., LTD. et al.) 08 July 2015 (2015-07-08) entire document | 1-27 |
| A | US 2015144977 A1 (JAPAN DISPLAY INC.) 28 May 2015 (2015-05-28) entire document | 1-27 |

☐ Further documents are listed in the continuation of Box C. ☑ See patent family annex.

* Special categories of cited documents:
- "A" document defining the general state of the art which is not considered to be of particular relevance
- "D" document cited by the applicant in the international application
- "E" earlier application or patent but published on or after the international filing date
- "L" document which may throw doubts on priority claim(s) or which is cited to establish the publication date of another citation or other special reason (as specified)
- "O" document referring to an oral disclosure, use, exhibition or other means
- "P" document published prior to the international filing date but later than the priority date claimed
- "T" later document published after the international filing date or priority date and not in conflict with the application but cited to understand the principle or theory underlying the invention
- "X" document of particular relevance; the claimed invention cannot be considered novel or cannot be considered to involve an inventive step when the document is taken alone
- "Y" document of particular relevance; the claimed invention cannot be considered to involve an inventive step when the document is combined with one or more other such documents, such combination being obvious to a person skilled in the art
- "&" document member of the same patent family

| Date of the actual completion of the international search | Date of mailing of the international search report |
|---|---|
| **15 June 2023** | **26 June 2023** |

| Name and mailing address of the ISA/CN | Authorized officer |
|---|---|
| **China National Intellectual Property Administration (ISA/CN)**<br>**China No. 6, Xitucheng Road, Jimenqiao, Haidian District, Beijing 100088** | Telephone No. |

Form PCT/ISA/210 (second sheet) (July 2022)

**INTERNATIONAL SEARCH REPORT**
**Information on patent family members**

International application No.
**PCT/CN2022/123422**

| Patent document cited in search report | Publication date (day/month/year) | Patent family member(s) | Publication date (day/month/year) |
|---|---|---|---|
| JP 2007172873 A | 05 July 2007 | JP 5235269 B2 | 10 July 2013 |
| CN 110581143 A | 17 December 2019 | CN 110581143 B | 21 September 2021 |
| CN 104766869 A | 08 July 2015 | WO 2016161731 A1 | 13 October 2016 |
| | | US 2017062486 A1 | 02 March 2017 |
| | | CN 104766869 B | 26 January 2018 |
| US 2015144977 A1 | 28 May 2015 | JP 2015103490 A | 04 June 2015 |
| | | JP 6219696 B2 | 25 October 2017 |
| | | US 9831391 B2 | 28 November 2017 |

Form PCT/ISA/210 (patent family annex) (July 2022)